# EUROPÄISCHE PATENTANMELDUNG

(11) **EP 2 605 091 A1**
(43) Veröffentlichungstag der Anmeldung: **19.06.2013**
(21) Anmeldenummer: 11193057.4
(22) Anmeldetag: 12.12.2011
(51) Int. Cl.: G05B 19/042, H01R 9/26, H05K 7/14

(54) **Hardwaresystem mit Drahtlosdatenübertragung sowie Verfahren zum Betreiben des Hardwaresystems**

(71) Anmelder: Benteler Automobiltechnik GmbH, 33102 Paderborn (DE)
(72) Erfinder: Roser, Jürgen, 38442 Wolfsburg (DE); Grünewald, Marek, 38118 Braunschweig (DE); Knye, Florian, 38104 Braunschweig (DE)
(74) Vertreter: Griepenstroh, Jörg

(57) **Zusammenfassung**

Die vorliegende Erfindung betrifft ein Hardwaresystem (1) zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen, aufweisend ein Grundmodul (2) mit einem Mastercontroller und mindestens ein in das Hardwaresystem (1) eingestecktes Einsteckmodul (7), das **dadurch gekennzeichnet** ist, dass das Einsteckmodul (7) per Drahtlosdatenübertragung mit einem Sensor und/oder Aktor und/oder Datennetz kommuniziert.

## Beschreibung

Die vorliegende Erfindung betrifft ein Hardwaresystem zur Modellbildung, Messung, Prüfung, Regelung und/oder Steuerung von elektrischen Schaltkreisen gemäß den Merkmalen im Oberbegriff von Patentanspruch 1.

Die vorliegende Erfindung betrifft weiterhin ein Verfahren zum Betreiben eines Hardwaresystems mit Drahtlosdatenübertragung gemäß den Merkmalen im Patentanspruch 13.

Bei der aktuellen Entwicklung von Kraftfahrzeugen spielt der Einbau von Elektronikkomponenten eine immer stärkere Rolle. Zu den originären elektrischen Verbrauchern in einem Kraftfahrzeug, wie beispielsweise der Motorelektronik oder aber der Beleuchtungsanlage, kommt eine Vielzahl an elektrischen Fahrerassistenz- sowie Komfortsystemen.

Auf seiten der Fahrerassistentsysteme gibt es Basiskomponenten, über die nahezu jedes neu gebaute Fahrzeug verfügt. Hierzu zählen ein Antiblockiersystem sowie ein elektronisches Stabilitätsprogramm. Beide Systeme nutzen eine Vielzahl von Sensoren und Aktoren, die an verschiedenen Orten des Kraftfahrzeugs angeordnet sind. So gibt es beispielsweise Radsensoren, die direkt im Bereich der Räder angeordnet sind, sowie Beschleunigungssensoren, die zentral im Kraftfahrzeug positioniert sind. Zur Auswertung der Sensorsignale sind wiederum verschiedene Steuergeräte in dem Kraftfahrzeug angeordnet, die über Regeleingriffe in die Motorelektronik oder aber das Bremssystem kritische Fahrzustände vermeiden.

Darüber hinaus verfügen Kraftfahrzeuge heutzutage über Sensoren, die permanent Umgebungsdaten sammeln und auswerten und somit einen Rückschluss über die aktuellen klimatischen Bedingungen sowie die Wetterlage oder auch die Stausituation zulassen. Auf Basis dieser Datenauswertung verändern sich dann die Betriebsfunktionen für Scheibenwischer, Klimaautomatik oder aber auch Stabilitätseingriffe in das Fahrverhalten. Beispielsweise wird bei regnerischem Wetter die Gebläsefunktion der Klimaautomatik auf die Scheiben erhöht sowie die Scheibenwischersensibilität verstärkt, so dass der Fahrer stets freie Sicht erhält.

Zur Vernetzung der einzelnen Elektronikkomponenten innerhalb des Kraftfahrzeugs, insbesondere der Sensoren, Steuergeräte und Aktoren untereinander, sind diese über Kabelleitungen mit dem Bordnetz und miteinander gekoppelt. Da die stetig zunehmende Vielzahl von Elektronikbauteilen eine schier unendliche Zahl verschiedener Kabelleitungen erfordern würde, kommunizieren die Elektronikkomponenten innerhalb eines Kraftfahrzeugs über mindestens ein BUS-Signal untereinander. Zumeist handelt es sich dabei um einen Can-BUS. Durch die Verwendung eines BUS-Kommunikationsweges der einzelnen Elektronikkomponenten untereinander ist es möglich, mehrere Komponenten an eine entsprechende Datenleitung zu koppeln. Die Datenleitung selber besteht dabei wiederum aus zwei, drei oder mehr einzelnen Kabelleitungen. Über die Datenleitung ist es möglich, verschiedene Kommunikationssignale zu versenden, wobei sich die einzelnen Elektronikbauteile, wie Steuergeräte, Sensoren und Aktoren, dann die jeweils relevanten Daten aus der Kommunikationsleitung auslesen bzw. Daten über die Kommunikationsleitung senden.

In einem Kraftfahrzeug werden jedoch verschiedenste Bauteile von Kraftfahrzeugzulieferern verbaut. Dabei gilt es, die Zuliefererbauteile der verschiedensten Zulieferhersteller auf einen Standard des jeweiligen Kraftfahrzeugherstellers oder aber des jeweiligen Kraftfahrzeugtyps zu bringen, so dass diese kompatibel in dem Kraftfahrzeug selber miteinander kommunizieren und agieren.

Bei technischen Verbesserungen während des Produktlebenszyklus einer Baureihe eines Kraftfahrzeugs, beispielsweise der Seriennachrüstung eines neueren Navigationssystems im Zuge einer Produktauffrischung, gilt es, Elektronikkomponenten mit neuesten Standards in ein bereits Jahre älteres, bestehendes Elektroniksystem zu implementieren.

Zur Entwicklung von Kraftfahrzeugen sind daher für jedes einzelne Bauteil aufwendige Tests und Probeläufe zu absolvieren. Im Anschluss hieran werden die einzelnen Komponenten zu Baugruppen zusammengefügt, die wiederum Tests und Probeläufe absolvieren. Alle Bauteilkomponenten werden dann in Prototypenfahrzeugen vereint und auch hier wiederum ausgiebig getestet. Die Erkenntnis aus der Entwicklung der Komponenten sowie der Prototypenkraftfahrzeuge fließen dann in Vorserienmodelle ein, wobei die bis dahin gesammelten Erkenntnisse eine spätere Volumenproduktion des Kraftfahrzeugmodels, insbesondere ohne Elektronikprobleme, zulassen.

Damit ein Elektronikbauteil eigenständig entwickelt und getestet werden kann, ohne in einem Kraftfahrzeug selber eingebaut zu sein, bedarf es der Simulation der Kraftfahrzeugumgebung. Hierzu hat sich die Hardware in the loop Methode etabliert, bei der eine reale elektronische Bauteilkomponente oder aber eine reale mechatronische Bauteilkomponente über ihre Ein- und Ausgänge an eine simulierte Umgebung angeschlossen wird. Der Simulator simuliert dabei in einem Zusammenspiel aus Hardware und Software die reale Umgebung des Gesamtsystems, also des Kraftfahrzeugs oder aber einer Unterbaugruppe einer Baugruppe des Kraftfahrzeugs. Hierzu bedarf es entsprechender Hardware sowie Entwicklungssoftware bei der Entwicklung des Bauteils. Als Hardware fungieren zumeist Computer, die in Laboren bzw. auf Prüfständen in Großgehäusen als Einschubsteckplätze modular aufgebaut sind. Solche Computergehäuse sind stationär an den Laborbetrieb gebunden und aufgrund ihrer äußeren Abmessungen sowie ihrer Verkablung zu den zu erprobenden oder zu evaluierenden Bauteilen stationär gebunden. Zur Erweiterung der Funktionsfähigkeit einer entsprechenden Prüfstandshardware werden neue Einsteckmodule eingesteckt, die dann eine weitere Reihe von Sensoren oder Aktoren ansteuern oder aber auswerten kann. Hierbei kommt es unter Umständen zu hardwaretechnischen und auch softwaretechnischen Kompatibilitätsproblemen auf Seiten des Simulators.

Zur Auswertung und Bedienung eines Simulators bedarf es wiederum eines Personal Computers mit Eingabemaske, über die dann die Simulationsumgebung erschaffen, simuliert und ausgewertet wird.

Zur Erprobung in einem Kraftfahrzeug, also auch zur mobilen Erprobung während einer Testfahrt, eignen sich vorerwähnte Simulatoren dann wiederum nicht. Hier wird zumeist auf Dummies oder aber Dongel zurückgegriffen, die bei Testfahrten ausschließlich eine Auswertung oder aber Simulation vornehmen, deren Ergebnisse im Nachhinein ausgewertet werden. Es ist jedoch auch mobile Testhardware bekannt, bei der entsprechende Gehäuse in einem Kraftfahrzeug auf dem Beifahrersitz oder aber im Kofferraum angeordnet werden, in die dann wiederum verschiedenste Einsteckmodule einbaubar sind, um so für einen jeweiligen Anwendungsfall die erforderliche Testhardware bereit zu stellen.

Aufgabe der vorliegenden Erfindung ist es, ausgehend vom Stand der Technik, ein modular konfigurierbares Hardwaresystem bereit zu stellen, das sowohl stationär als auch mobil einsetzbar ist und das gegenüber aus dem Stand der Technik bekannten Hardwaresystemen bedeutend einfacher einsetzbar ist.

Die zuvor genannte Aufgabe wird erfindungsgemäß mit einem Hardwaresystem gemäß den Merkmalen im Patentanspruch 1 gelöst.

Die zuvor genannte Aufgabe wird weiterhin mit einem Verfahren zum Betreiben des erfindungsgemäßen Hardwaresystems mit den Merkmalen im Patentanspruch 13 gelöst.

Vorteilhafte Ausführungsvarianten der vorliegenden Erfindung sind Bestandteil der abhängigen Patentansprüche.

Das erfindungsgemäße Hardwaresystem wird zur Modellbildung, Messung, Prüfung, Regelung und/oder Steuerung von elektrischen Schaltkreisen und/oder Datennetzen und/oder Sensoren und/oder Aktoren, insbesondere beim Einsatz in Automotiveanwendungen verwendet und weist ein Grundmodul mit einem Mastercontroller und mindestens ein in das Hardwaresystem eingestecktes Einsteckmodul auf. Das Hardwaresystem ist erfindungsgemäß dadurch gekennzeichnet, dass das Einsteckmodul per Drahtlosdatenübertragung mit einem Sensor und/oder Aktor und/oder Datennetz kommuniziert.

Eine Drahtlosdatenübertragung ist dabei die Übertragung von Daten ohne physische Verbindung zwischen Sender und Empfänger, beispielsweise in Form von Kabelleitungen. Die Drahtlosdatenübertragung kann dabei im Rahmen der Erfindung per Infrarot, W-Lan, Funk, Radiowellen, Bluetooth oder in sonstiger Form erfolgen. Hierdurch wird im Rahmen der Erfindung erreicht, dass das Hardwaresystem sehr leicht in eine Modellumgebung oder aber in einen Prüfstandsaufbau integrierbar ist.

Im Falle von zu steuernden Aktoren oder aber auszulesenden Sensoren wird das Hardwaresystem mit dem Einsteckrnodul und der Drahtlosdatenübertragungsfunktion des Einsteckmoduls in der Nähe des anzuschließenden Sensors und/oder Aktors aufgestellt. Durch die Drahtlosdatenübertragungsfunktion ist keine direkte physische Kopplung und somit keinerlei Verkabelungsarbeit oder Ähnliches notwendig. Aufwendige Rüstzeiten bzw. Prüfstandsaufbauzeiten entfallen somit gänzlich. Ebenfalls entfallen gänzlich die Verkabelungsarbeiten mit bis zu mehreren hundert Kabeln, beispielsweise am Prüfstand eines Verbrennungsmotors. Bei einer potentiellen Fehlersuche aufgrund eines Kabelbruchs und/oder eines falsch angeschlossenen Kabels entstehen Zeiten, in denen der Prüfstand nicht genutzt wird, was erfindungsgemäß gänzlich entfällt. Hierzu kann das Hardwaresystem eine Fehlermeldung des entsprechenden Sensors und/oder Aktors anzeigen, so dass direkt festgestellt werden kann, wo sich ein fehlerhaftes Bauteil und/oder ein fehlerhaftes externes Element, das mit dem Hardwaresystem kommuniziert, angeordnet ist.

Ebenfalls ist es im Rahmen der Erfindung möglich, externe Datennetze über die Drahtlosdatenübertragungsfunktion des Einsteckmoduls auszulesen oder aber mit diesen zu kommunizieren.

Das Einsteckmodul mit Drahtlosdatenübertragungsfunktion weist somit eine Sender- und/oder Empfängereinheit auf, die in der Lage ist, mindestens eine Drahtlosdatenübertragungsfunktion zu beinhalten. Dies kann beispielsweise Funk, Bluetooth, Infrarot, W-Lan oder ein sonstiger Drahtlosdatenübertragungsstandard sein. Im Rahmen der Erfindung ist es jedoch auch möglich, nicht standardisierte Drahtlosdatenübertragungswege mit dem erfindungsgemäßen Hardwaresystem auszuführen, hierzu wird ein Einsteckmodul mit entsprechendem Standard in das Hardwaresystem eingesteckt und wiederum über die Sender- und/oder Empfängereinheit kommuniziert.

Im Rahmen von Prototypenerprobungen im Automobilbereich eignet sich das erfindungsgemäße Hardwaresystem insbesondere dadurch, dass aufwendige Verkabelungsarbeiten innerhalb eines Prototypenkraftfahrzeugs gänzlich entfallen. So können beispielsweise Sensoren und/oder Aktoren im Motorraum problemlos von einem in dem Fahrgastraum angeordneten Hardwaresystem aus geregelt und/oder gesteuert bzw. ausgelesen werden, ohne dass Verkabelungsarbeiten notwendig sind.

Bereits viele Sensoren, Aktoren bzw. Modems oder aber auch sonstige Prüfstandsperipheriegeräte verfügen heutzutage bereits herstellerseitig vielfach über Drahtlosdatenübertragungsfunktionen, die in der Regel mindestens einen Standard, beispielsweise Bluetooth oder aber Infrarot erfüllen. Durch die geeignete Wahl eines Einsteckmoduls ist es somit problemlos möglich, das Hardwaresystem mit entsprechenden Peripheriegeräten zu koppeln, um verschiedene Mess-, Prüf-, Regelungs- und/oder Steuerungsaufgaben durchzuführen. Im Rahmen der Erfindung ist das Grundmodul des Hardwaresystems mit einem Zwischenmodul erweiterbar, wobei das Zwischenmodul in Turmbauweise und/oder Sandwichbauweise an das Grundmodul anschließbar ist. Bei dem Zwischenmodul handelt es sich in einfachster Ausführungsvariante um ein Zusatzmodul, dass in Art eines Deckels auf das Grundmodul aufsteckbar und/oder aufschraubbar, mithin koppelbar ist. Durch das Zwischenmodul wird es somit ermöglicht, mehrere Einsteckmodule an das Hardwaresystem anzuschließen, um somit eine Vielzahl unterschiedlicher Drahtlosübertragungsstandards gleichzeitig ausführen zu können und/oder eine Vielzahl von Aktoren, Sensoren oder Datennetzen, die es dem Hardwaresystem ermöglichen, mit einer Vielzahl von Aktoren, Sensoren und/oder Datennetzen zu kommunizieren.

Über die verschiedenen Drahtlosdatenübertragungseinsteckmodule ist es mithin möglich, mit den Sensoren, Aktoren oder Datennetzen gleichzeitig, insbesondere parallel zu kommunizieren. Aufgrund der zentralen Steuerung eines Hardwaresystems ist es weiterhin möglich, die mindestens zwei Drahtlosdatenübertragungswege derart aufeinander abzustimmen, dass diese sich nicht gegenseitig stören oder aber beeinflussen. Das Grundmodul ist weiterhin mit zwei, drei oder mehr Zwischenmodulen in Turmbauweise bzw. Sandwichbauweise derart zu erweitern, dass theoretisch 50, 60 oder mehr Zwischenmodule aufeinander steckbar bzw. schraubbar sind, wobei eine praktisch sinnvolle Obergrenze, die aufeinander zu steckenden Zwischenmodule nach oben hin beschränken sollte. Diese liegt schätzungsweise bei 100 Zwischenmodulen.

Jedes Zwischenmodul und/oder das Deckelmodul wird weiterhin vorzugsweise über das Grundmodul mit einer Grundspannung versorgt, insbesondere über eine zentrale Versorgungsleitung, wobei jedes Modul die Grundspannung auf ihrer Modulebene wiederum unterverteilt.

Die Versorgungsleitung selbst ist dabei in der Modulsteckverbindung integriert oder die Versorgungsleitung ist als separate Versorgungssteckverbindung zwischen den Modulen ausgebildet. Hierüber ist es möglich, die interne Betriebsspannung des Hardwaresystems auf die einzelnen Modulebenen zu verteilen und dort auf die jeweils benötigte Spannung zu transformieren. Das Hardwaresystem ist hierdurch besonders einfach mit einem Aufbau ausgebildet, da eine zentrale Spannungsversorgung jeweils ebenenweise auf die benötigten Ebenenspannungen gewandelt wird.

Weiterhin besonders bevorzugt sind die Modulsteckverbindungen aller Module gleich ausgebildet, so dass bei Austausch und/oder Ergänzung und/oder Entnahme eines Moduls, insbesondere eines Zwischenmoduls die Modulsteckverbindungen der verbleibenden Module wiederum lösbar ineinander steckbar sind. Im Falle eines Hardwaresystems mit mehreren Zwischenmodulen ist es bei Entnahme eines Zwischenmoduls somit in einfacher, schneller und sicherer Weise möglich, die verbleibenden Zwischenmodule wiederum lösbar ineinander zu stecken. Das Hardwaresystem ist sofort danach wieder einsetzbar, ohne das aufwendige neue Verkabelungsarbeiten oder sonstige Anschluss- oder auch Programmierarbeiten durchzuführen sind. Ebenfalls bei Defekt eines Zwischenmoduls ist dieses in besonders einfacher Art und Weise austauschbar oder aber bei beliebiger Erweiterung mit zusätzlichen Zwischenmodulen sind diese in einfacher und schneller Weise an dem Hardwaresystem ergänzbar.

Der Akkumulator selber ist im autarken Betrieb des Hardwaresystems als einzige Spannungsquelle vorgesehen, er kann jedoch auch in Ergänzung zu dem externen Stromnetz, insbesondere bei Spannungsschwankungen und/oder Spannungsausfall redundant eingesetzt werden. Im Rahmen der Erfindung ist es bei Erweiterung des Hardwaresystems um mehr als beispielsweise zwei Dutzend Zwischenmodule möglich, Akkumulatoren in Reihe oder aber parallel für einzelne Zwischenmodule mit anzuschließen, so dass Spannungsschwankungen innerhalb des Hardwaresystems und auch Spannungsschwankungen des Stromnetzes über den oder die Akkumulatoren ausgleichbar sind. Hierzu können die Akkumulatoren über die Einsteckmodule mit dem Hardwaresystem gekoppelt werden oder aber als Zwischenmodul, welches als Akkumulator ausgebildet ist, in dem Hardwaresystem integriert sein.

Weiterhin bevorzugt wird jedes Modul von dem Grundmodul aus mit der Grundspannung versorgt und jedes Zwischenmodul transformiert die Grundspannung auf die jeweils lokal benötigte Spannung. Insbesondere sind dies 3,3 Volt und 5 Volt, da dies Versorgungsspannungen sind, die für viele handelsübliche Messsensoren und Aktuatoren benötigt werden. Ebenfalls ist es möglich, über das Zwischenmodul sowie das Einsteckmodul die Grundspannung direkt weiterzuleiten, so dass ein angeschlossener Aktor direkt über das Hardwaresystem, beispielsweise mit 12 Volt versorgt wird.

Im Rahmen der Erfindung ist es insbesondere möglich, dass das Grundmodul alle anderen Module in einen Sleepmodus schaltet, so dass an diesem keine Spannung anliegt. In der Folge ist das Grundmodul selbst im Sleepmodus noch aktiv. Hierdurch ist es sowohl automatisch als auch manuell möglich, das Hardwaresystem schnell in einen stromsparenden Zustand zu versetzen. Über eine Standby-Funktion des Grundmoduls selber können gewisse Grundaufgaben sowie ein Vorhalten des letzten Softwarebetriebszustandes über das Grundmodul sichergestellt werden, sodass ein schnelles Reaktivieren des Hardwaresystems erreicht wird. Durch diese Funktion eignet sich das erfindungsgemäße Hardwaresystem insbesondere für mobile Ersatzzwecke, da besonders lange Betriebszeiträume durch ein Deaktivieren bei Nichtbenutzung des Hardwaresystems erreicht werden können.

Weiterhin besonders bevorzugt sind über das Grundmodul und/oder ein Zwischenmodul wahlweise und/oder gleichzeitig Arbeitsspannungen oder auch Lastspannungen von im Wesentlichen 3,3 Volt und/oder 5 Volt und/oder 12 Volt an andere Module und/oder Einsteckmodule leitbar. Die Arbeitsspannungen können dann wiederum bevorzugt direkt zur Ansteuerung und/oder zum Betrieb und/oder zum Auslesen von Aktuatoren und/oder Messsensoren und/oder Datennetzen nutzbar sein. Die Arbeitsspannung ist weiterhin bevorzugt direkt als Lastspannung an ein externes Stellelement weiterleitbar. Aktuatoren können im Rahmen der Erfindung beispielsweise ein Scheibenwischermotor, Stellaktuatoren, Servomotoren oder sonstige aktive elektrische, elektronische oder mechatronische Bauteile sein. Datennetze sind im Rahmen der Erfindung insbesondere Datenkommunikationsnetze, beispielsweise in Form eines Bussystems.

Die Lastspannung selber für ein externes Stellelement wird weiterhin bevorzugt von einem externen Stromnetz und/oder einer externen Stromquelle bezogen, wobei diese über das Hardwaresystem steuerbar bzw. schaltbar ist, insbesondere über ein Einsteckmodul. Hierzu weist das Einsteckmodul wiederum besonders bevorzugt ein Potentiometer und/oder ein Leistungstreiber und/oder einen Transformator auf, wobei der Teil des Einsteckmoduls, der die Spannungssteuerung und/oder Spannungstransformation vornimmt, außerhalb des Gehäuses des Hardwaresystems angeordnet ist. Hierdurch erfolgt kein Wärmeeintrag in das Hardwaresystem selber, weshalb auf aufwendige Kühleinrichtungen zum Betrieb des Hardwaresystems, insbesondere zum Dauerbetrieb des Hardwaresystems verzichtet werden kann.

Im Rahmen der Erfindung ist weiterhin mindestens ein Zusatzmodul an dem Hardwaresystem integriert, wobei das Zusatzmodul einen Spannungswandler aufweist, der die Spannung von im Wesentlichen 12 Volt lokal in dem Zusatzmodul in eine dort benötigte Spannung transformiert, vorzugsweise weist jedes Zusatzmodul einen Spannungswandler auf, insbesondere einen getakteten Spannungswandler. Bei dem Zusatzmodul kann es sich im Rahmen der Erfindung um ein Zwischenmodul oder aber auch um ein Einsteckmodul handeln. Durch den Spannungswandler selbst ist es möglich, die Versorgungsspannung des Hardwaresystems von im Wesentlichen 12 Volt, in eine jeweils lokal benötigte Spannung zu transformieren. Bei dem Spannungswandler selber handelt es sich besonders bevorzugt um einen getakteten Spannungswandler, insbesondere einen einstellbaren Spannungswandler, so dass die Spannung über beispielsweise ein Einsteckmodul frei einstellbar ist.

Die Modulsteckverbindungen aller Module, also insbesondere aller Zwischenmodule, sind gleich, so dass bei Austausch und/oder Ergänzung und/oder Entnahme eines Moduls, insbesondere eines Zwischenmoduls, die Modulsteckverbindungen der verbleibenden Module wiederum in einfacher Weise lösbar ineinander steckbar sind. Somit können bei einem bereits in einer Umgebung implementierten Hardwaresystem in einfacher Art und Weise weitere Zwischenmodule ergänzt oder aber Zwischenmodule entfernt werden. Durch einfaches wiederum lösbares Ineinanderstecken der verbleibenden Module ist das Hardwaresystem sofort wieder einsatzfähig. Auch hier entfallen aufwendige Anschluss- oder Umbauarbeiten, insbesondere aufwendige Verkabelungsarbeiten. Durch wiederum einfaches Einstecken der Einsteckmodule in das Gehäuse des Hardwaresystems können verschiedenste Peripheriebauteile bzw. Sensoren oder Aktoren wiederum betriebssicher an das Hardewaresystem gekoppelt werden.

Im Rahmen der Erfindung ist dem Hardwaresystem, insbesondere einem jeden Einsteckmodul, weiterhin ein Empfangsmodul zuordnenbar, wobei das Einsteckmodul und das Empfangsmodul über Drahtlosdatenkommunikation miteinander verbindbar sind. Bei dem Empfangsmodul handelt es sich um ein zu dem Hardwaresystem gehörendes Peripheriebauteil, dass es ermöglicht, auch Sensoren, Aktoren und/oder Datenübertragungsnetze ohne Drahtlosdatenkommunikationsmöglichkeit an das Hardwaresystem per Drahtlosdatenkommunikaton zu koppeln. Die von dem Hardwaresystem generierten Daten werden somit über den Sender des Einsteckmoduls per Drahtlosdatenkommunikation an einen Empfänger des Empfangsmoduls gesendet und dort in ein physisches Datenprotokoll moduliert bzw. transferiert und in Regelungs- oder Steuerungsbefehle umgewandelt. Ein an das Empfangsmodul angeschlossener Aktor und/oder ein an das Empfangsmodul angeschlossenes Datennetz erhalten somit von dem Empfangsmodul per physischer Kopplung, also per Kabelleitung, entsprechende Daten.

Ebenfalls ist ein paralleler, gleichzeitig oder zeitlich versetzter Betrieb des Empfangsmoduls als Sendemodul möglich. Hierbei werden dann wiederum Daten über einen Sender des Empfangsmoduls an einen Empfänger des Einsteckmoduls gesendet und von dem Einsteckmodul an das Hardwaresystem weitergeleitet. Ein entsprechender Dauerbetrieb von Senden und/oder Empfangen ist im Rahmen der Erfindung möglich. Ebenfalls ist es im Rahmen der Erfindung vorstellbar, dass zwei, drei oder mehrere Empfangsmodule von einem Einsteckmodul aus ansteuerbar sind.

Das Empfangsmodul wird in einfachster Anschlussmöglichkeit über die Spannungsversorgung des Peripheriebauteils, an das es angeschlossen ist, mit versorgt. Da dies je nach Anwendungsfall mitunter nicht ausreichend ist, ist das Empfangsmodul weiterhin an das Kraftfahrzeugbordnetz und/oder einen Akkumulator anschließbar, so dass es insbesondere mobil einsetzbar ist. Ebenfalls ist es im Rahmen der Erfindung vorstellbar, dass das Empfangsmodul an ein Stromnetz angeschlossen wird. Im Rahmen der Erfindung können somit auch über das Empfangsmodul Lastströme an ein an das Empfangsmodul angeschlossenes Peripheriebauteil geschaltet werden. Beispielsweise kann ein Stellmotor über das Empfangsmodul entsprechend gesteuert werden.

Insbesondere eignet sich das erfindungsgemäße Hardwaresystem für mobile Einsätze, bevorzugt bei der Erprobung von Prototypen oder für Testzwecke in Kraftfahrzeugen. Hierzu sind das Grundmodul mit dem Einsteckmodul und optionalen Zwischenmodulen sowie weiterhin optional dazugehörige Empfangsmodule mobil einsetzbar. Insbesondere erfolgt eine Spannungsversorgung sowohl des Grundmoduls, als auch der optionalen Empfangsmodule dann über Akkumulatoren bzw. sind diese an ein Kraftfahrzeugbordnetz anschließbar.

Das Empfangsmodul weist weiterhin besonders bevorzugt einen Treiber auf, mit dem der an das Empfangsmodul angeschlossene Sensor und/oder Aktor regelbar und/oder steuerbar ist. Hierbei kann es sich um die Treibersoftware und/oder Treiberhardware handeln, so dass über das Empfangsmodul das jeweils angeschlossene externe Element bzw. Peripheriebauteil entsprechend regelbar und/oder steuerbar ist.

Im Rahmen der Erfindung weist weiterhin das Grundmodul, insbesondere das Modular mit Zwischenmodulen erweiterte Grundmodul, ein spritzwassergeschütztes und staubgeschütztes Gehäuse auf. Gerade für den Einsatz an Prüfständen oder aber für den mobilen Einsatz kann es unter Umständen notwendig sein, dass das erfindungsgemäße Hardwaresystem entsprechend robust ausgebildet ist. Sofern es mit Fetten oder Schmierstoffen oder aber auch bei einem Außenprüfstand mit Witterungseinflüssen in Kontakt kommt, wird hierdurch eine einwandfreie Funktion des Hardwaresystems sichergestellt.

Bei der Erprobung von Kraftfahrzeugen, insbesondere von Versuchsträgern, Offroadfahrzeugen oder aber auch im Nutzfahrzeugbereich oder aber im militärischen Kraftfahrzeugbereich werden mitunter Outdoortests unter widrigen Witterungsbedingungen, aber auch mit entsprechend auf das Testequipment einwirkenden Einflüssen durchgeführt, die sich im Zuge der Erprobung nicht vermeiden lassen. Durch das erfindungsgemäße Hardwaresystem wird jedoch eine Möglichkeit aufgrund des spritzwassergeschützten und staubgeschützten Gehäuses gegeben, diesen Witterungseinflüssen und Nutzungsbedingungen resistent gegenüber zu stehen und einen einwandfreien Testbetrieb zu ermöglichen.

Weiterer Bestandteil der vorliegenden Erfindung ist ein Verfahren zum Betreiben eines Hardwaresystems mit mindestens einem der zuvor genannten Merkmale, wobei das Verfahren dadurch gekennzeichnet ist, dass das Grundmodul mit dem Einsteckmodul über einen systemeigenen Bus kommuniziert, wobei das Einsteckmodul die für seine Verwendung relevanten Daten aus dem systemeigenen Bus ausliest und per Drahtlosdatenübertragung an das Empfangsmodul sendet.

Im Rahmen der Erfindung muss das Empfangsmodul auch nicht derart als eigenständiges physisches Bauteil ausgebildet sein, es kann auch ein bereits in einem Prüfstandsequipmentbauteil vorhandenes Empfangsmodul zum Empfang von Drahtlosdaten sein. Ferner ist im Rahmen der Erfindung auch ein inverser Datenaustausch möglich, wobei die von dem Einsteckmodul empfangenen Drahtlosdaten ausgewertet werden und die für die Prüf- und/oder Testzwecke relevanten Daten über den systemeigenen Bus an das Grundmodul bzw. ein in dem Grundmodul angeordneten Controller weitergibt.

Im Rahmen der Erfindung ist es weiterhin ein bevorzugter Bestandteil des Verfahrens, dass das Grundmodul und das Zwischenmodul über den systemeigenen Bus miteinander kommunizieren, wobei das Zwischenmodul die für in dem Zwischenmodul angeordneten Einsteckmodule relevanten Daten ausliest und an die Einsteckmodule weiterleitet, wobei die Einsteckmodule mit einem jeweiligen Empfangsmodul per Drahtlosübertragung kommunizieren. Auch hier ist im Rahmen der Erfindung wiederum ein inverser Datenaustausch möglich, so dass die von den Einsteckmodulen empfangenen Daten über das Zwischenmodul in den systemeigenen Bus eingespeist werden.

Das Hardwaresystem zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen weist eine Grundplatine mit einem Mastercontroller und mindestens eine Zusatzplatine mit einem Slavecontroller auf. Das Hardwaresystem ist erfindungsgemäß dadurch gekennzeichnet, dass der Mastercontroller und der Slavecontroller über einen systemeigenen Bus, vorzugsweise über einen SPI-Bus, des Hardwaresystems kommunizieren, wobei an dem Slavecontroller mindestens ein Einsteckmodul anschließbar ist und über das Einsteckmodul externe Regler und/oder Messsensoren und/oder Aktoren und/oder Datennetze auslesbar und/oder steuerbar sind.

Im Rahmen der Erfindung weist das Hardwaresystem ein Gehäuse auf, das modular optional erweiterbar ist. Das Gehäuse setzt sich aus einem Grundmodul, optionalen Zwischenmodulen und einem Deckelmodul zusammen, wobei die einzelnen Module untereinander über den systemeigenen Bus des Hardwaresystems kommunizieren. Jede Modulebene weist einen Controller auf, wobei in dem Grundmodul ein Mastercontroller angeordnet ist, und die anderen Ebenen diesem Mastercontroller als Slavecontroller unterstellt werden.

Das erfindungsgemäße Hardwaresystem ist beliebig erweiterbar, wobei die einzelnen Modulebenen durch beliebige Anordnung von Zwischenmodulen turmartig und/oder sandwichartig aufeinandersetzbar sind. In die einzelnen Modulebenen sind im Rahmen der Erfindung Einsteckmodule lösbar einsteckbar, die ein einfaches und sicheres Anschließen von externen Reglern und/oder Messsensoren und/oder Aktoren ermöglichen sowie Datennetze über das Einsteckmodul auslesbar und/oder übersetzbar sind.

Bei Reglern, Sensoren und/oder Aktoren handelt es sich dabei im Rahmen der Erfindung um alle erdenklichen Sensoren, Aktoren und/oder Regler, die im Rahmen von Prüfstandsarbeiten oder Prototypen Erprobung eingesetzt werden. Ferner handelt es sich um alle erdenklichen elektrischen, elektronischen und mechatronischen Bauteile, die zur Erprobung oder aber auch zur Evaluierung als Serienbauteile insbesondere in Automotiveanwendungen eingesetzt werden.

Im Rahmen der Erfindung ist es aufgrund der Kommunikation des Mastercontrollers mit den Slavecontrollern über den systemeigenen Bus möglich die zu tauschenden Datenmengen schnell und unkompliziert über die einzelnen Modulebenen zu leiten. Jedes Modul liest dann aus dem systemeigenen Bus wiederum die für das Modul selber bzw. die Einsteckmodule relevanten Daten aus und verwertet diese auf der Modulebene weiter. Der systemeigene Bus kann dabei im Rahmen der Erfindung jedes beliebige Signal sein, mit dem es möglich ist eine Datenweiterleitung für mehrere Teilnehmer zu ermöglichen.

Im Rahmen der Erfindung wird besonders bevorzugt ein SPI-Bus eingesetzt, wobei es sich bei dem SPI-Bus um einen Serial Peripheral Interface handelt. Der SPI-Bus weist einen einfachen Standard für einen synchronen seriellen Datenbus auf, mit dem digitale Schaltungen nachdem Master Slaveprinzip miteinander verbunden werden können.

Bevorzugt weist das Hardwaresystem eine gemeinsame Busleitung auf, die sich insbesondere aus drei gemeinsamen Leitungen zusammensetzt, an denen jeder Teilnehmer, also jede Modulebene angeschlossen ist. Im Rahmen der Erfindung kann das Hardwaresystem jedoch auch mehr oder weniger Leitungen haben, die die einzelnen Modulebenen miteinander verbinden. Vorzugsweise wird ein systemeigener Bus derart gewählt, dass unterschiedliche Taktfrequenzen über den Bus übertragbar sind,so dass der Bus innerhalb unterschiedlicher Taktfrequenzen arbeiten kann. Der systemeigene Bus des erfindungsgemäßen Hardwaresystems zeichnet sich insbesondere dadurch aus, dass er eine große Spannbreite von verschiedenen auch prinzipiell zueinander inkompatiblen Geräten ermöglicht.

Insbesondere bietet der systemeigene Bus des Hardwaresystems, vorzugsweise als serieller Bus, die Möglichkeit die modulare Erweiterungsfähigkeit des Hardwaresystems zu realisieren. Jedes Einsteckmodul besitzt einen Speicherbaustein, auf den die Modulkennung des Einschubmoduls wiederum hinterlegt ist. Bei Programmstart oder aber auch bei Reset des Hardwaresystems fragt der Mastercontroller alle Slavecontroller ab, welche Einsteckmodule potentiell oder aber möglicherweise in das Hardwaresystem eingesteckt sind. Die Slavecontroller haben wiederum auf der Modulebene eines Zwischenmoduls direkten Zugriff auf das Einsteckmodul.

Die Istverbauliste der Einsteckmodule wird mit einer im Programmcode hinterlegten Sollverbauliste verglichen und kann somit Abweichungen feststellen. Die Sollverbauliste kann auf Grund der einfachen Bedienbarkeit des Hardwaresystems direkt am Hardwaresystem oder aber über ein externes Kontrollinstrument beispielsweise einen Computer festgelegt, adaptiert oder geändert werden. Der Vergleich der Sollverbauliste mit der Istveblauliste kann auch während des Betriebs des Hardwaresystems manuell oder aber automatisch zyklisch durchgeführt werden, umso zu erkennen, ob Laufzeit Einsteckmodule entfernt bzw. eingesteckt werden oder aber ob Fehler oder Ausfälle an bereits eingesteckten Einsteckmodulen aufgetreten sind. Wird eine Abweichung festgestellt, kann eine entsprechende Fehlermeldung erzeugt werden und/oder der Programmablauf unterbrochen oder aber umgestellt werden.

In einer Grundausführungsvariante des Hardwaresystems ist die Grundplatine in einem Grundmodul angeordnet, wobei in das Grundmobil optional ein Einsteckmodul einsteckbar ist, wobei das Einsteckmodul über den Mastercontroller ansteuerbar ist. Das Hardwaresystem weist somit in einfachster Ausführungsvarainte ein Gehäuse auf, vorzugsweise ein metallisches Gehäuse insbesondere ein leichtmetallisches Gehäuse, in dem eine Grundplatine mit dem Mastercontroller angeordnet ist. In das Gehäuse besteht die Möglichkeit ein Einsteckmodul einzustecken, dass wiederum mit der Grundplatine gekoppelt wird und es somit ermöglicht ein externes Peripheriebauteil, beispielsweise einen Aktor, einen Sensor anzusteuern oder zu regeln bzw. auszulesen oder aber dem Hardwaresystem es ermöglicht mit einem externen Datennetz, beispielsweise einem Kraftfahrzeugbus zu kommunizieren. Das Einsteckmodul ist dann direkt über den Mastercontroller ansteuerbar.

Auf der Modulebene des Grundmoduls kommuniziert der Mastercontroller mit dem in das Grundmodul lösbar eingesteckte Einsteckmodul über den systemeigenen Bus des Hardwaresystems oder der Mastercontroller kommuniziert mit dem Einsteckmodul über einen von dem systemeigenen Bus verschiedenes Datenprotokoll. Hierbei kann es sich dann um ein Datenprotokoll handeln, dass es ermöglicht eine direkte Kommunikation zwischen dem Mastercontroller und dem Einsteckmodul herzustellen. Ebenfalls kann ein zusätzlicher Controller in dem Grundmodul angeordnet sein, der aus dem systemeigenen Bus des gesamten Hardwaresystems die für das Einsteckmodul erforderlichen Daten oder Steuerungssignale ausliest und dann wiederum ebenenintern auf Modulebene des Grundmoduls mit dem Einsteckmodul kommuniziert.

Im Rahmen der Erfindung werden weiterhin besonders bevorzugt mindestens zwei Empfangsmodule von einem Einsteckmodul aus angesteuert, wobei die Empfangsmodule voneinander verschiedene Aufgaben wahrnehmen. Dies erfolgt im Rahmen der Erfindung besonders bevorzugt über einen Drahtlosdatenkommunikationsstandard, beispielsweise per Bluetooth oder W-Lan. Im Rahmen der Erfindung ist es jedoch auch möglich, dass ein Einsteckmodul zwei verschiedene Drahtlosdatenstandards beherrscht und auf einem Drahtlosdatenstandard, beispielsweise Bluetooth mit einem Empfangsmodul kommuniziert und auf einem anderen Drahtlosdatenstandard, beispielsweise Infrarot, mit einem weiteren Empfangsmodul kommuniziert. Die Kommunikation kann wiederum zeitgleich parallel oder aber auch zeitlich aufeinanderfolgend durchgeführt werden.

Im Rahmen der Erfindung ist es insbesondere für den mobilen Einsatz des Hardwaresystems möglich, dass die Empfangsmodule und/oder Einsteckmodule und/oder Zwischenmodule in einen energiearmen Modus geschaltet werden, sobald kein Datenaustausch stattfindet, wobei die Module in Echtzeit wieder in den Normalmodus geschaltet werden, sobald ein Datenaustausch beginnt. Im Rahmen der Erfindung kann auch das Grundmodul in den energiearmen Modus schaltbar sein. Im Rahmen der Erfindung ist es hiermit möglich, besonders hohe Laufzeiten des Systems, insbesondere im Akkubetrieb zu ermöglichen. Durch die Fähigkeit in Echtzeit von dem Ruhemodus wiederum in den Normalmodus zu gelangen, ist es dennoch möglich, mit dem Hardwaresystem Prüf-, Mess-, Regeiungs- und/oder Steuerungsaufgaben in Echtzeit durchzuführen.

Im Rahmen der Erfindung werden weiterhin standardisierte Drahtlosdatenübertragungsprotokolle von einem Einsteckmodul ausgelesen und/oder gesendet, sodass das Einsteckmodul mit handelsüblichen Drahtlosdatenempfängern und/oder Drahtlosdatenschnittstellen kommunizieren kann. Über diese Möglichkeit des erfindungsgemäßen Verfahrens ist es möglich, mit dem Hardwaresystem mit allen Drahtlosdatenübertragungsstandards kommunizieren zu können.

Im Rahmen der Erfindung ist es somit möglich, durch einfachen Austausch oder Ergänzung eines Einsteckmoduls in dem Hardwaresystem verschiedenste Drahtlosdatenübertragungsstandards zu erfüllen und es dem Hardwaresystem zu ermöglichen, mit verschiedensten Drahtlosdatenübertragungsstandards zu kommunizieren.

Durch Einstecken des Einsteckmoduls wird dieses automatisch mit dem Hardwaresystem initialisiert bzw. autoadressiert, und stellt somit die Kompatibilität zwischen Hardwaresystem sowie Drahtlosdatenübertragungsstandard direkt sicher. Aufwendige Installationsarbeiten von entsprechenden Drahtlosdatenübertragungssendern und Empfängern, insbesondere softwaretechnische Einrichtungsarbeiten zur Applikation von Drahtlosdatenübertragungssystemen auf bereits vorhandene Prüfstandshardware, entfallen somit wiederum gänzlich. Die vorliegende Erfindung betrifft weiterhin ein Verfahren zum Betreiben eines Hardwaresystems, wobei das Hardwaresystem insbesondere zumindest eines der zuvor genannten Merkmale ausweist, und das Verfahren dadurch gekennzeichnet ist, dass ein externes Element mit einem Einsteckmodul kommuniziert, wobei das Einsteckmodul die bereitgestellten und/oder abgefragten Daten filtert und zu einem mit dem Einschubmodul gekoppelten Slavecontroller weitergibt und/oder von diesem empfängt und das der Slavecontroller die empfangenen oder gesendeten Daten über den systemeigenen Bus des Hardwaresystems an den Mastercontroller weitergibt oder von diesem empfängt.

Hierdurch ist es mit dem erfindungsgemäßen Hardwaresystem möglich eine Vielzahl von Aktoren und/oder Sensoren gleichzeitig zu regeln, zu steuern, zu messen, zu prüfen und/oder ebenfalls gleichzeitig eine Modelumgebung zu simulieren sowie mit externen Datennetzen zu kommunizieren. Gleichzeitig wird es auf Grund der Einsteckmodule ermöglicht, eine hohe Kompatibilität des erfindungsgemäßen Hardwaresystems sicherzustellen, da die Einsteckmodule zu dem Hardwaresystem kompatibel sind und jeweils bevorzugt eine Treiberhardware und eine Teibersoftware für das an das Einsteckmodul gekoppelte externe Element aufweisen. Aufwendige Prüfstandsaufbauten, sowie Verkabelungen und Treiberinstallationen so wie das Lösen von Kompatibilitätsproblemen entfallen bei den erfindungsgemäßen Hardwaresystem gänzlich.

Hierzu besteht bei dem erfindungsgemäßen Verfahren weiterhin die Möglichkeit das zwei Slavecontroller an den Mastercontroller angeschlossen werden und ein Datenprotokoll über den systemeigenen Bus gesendet wird, wobei jeder Slavecontroller die für ihn adressierten Daten aus dem Datenprotokoll ausliest und für ein ebeneninternes Datenprotokoll oder eine ebeneninterne Datenkommunikation verwendet, wobei über das ebeneninterne Datenprotokoll die Einsteckmodule über den jeweiligen Slavecontroller ansteuerbar sind. Die Einsteckmodule kommunizieren somit mit dem Slavecontroller und geben an diesen die von den an den Einsteckmodulen angeschlossenen externen Elementen empfangenen Daten weiter oder empfangen vom Slavecontroller Regelungs- oder Steuerungsbefehle, die sie wiederum an die angeschlossenen externen Elemente weiterleiten. Hierdurch entsteht eine Filterungsfunktion, so dass der systemeigene Bus des Hardwaresystems sich auf einen wesentlichen Datenaustausch reduzieren kann, wobei auf Grund der breiten Kompatibilität des systemeigenen Busses des Hardwaresystems Kompatibilitätsprobleme annähernd gänzlich vermieden werden.

Der Slavecontroller liest weiterhin auf Grund der Modulkennung des Einsteckmoduls die relevanten Daten aus dem systemeigenen Bus aus. Er gibt dann wiederum ebenenintern, beispielsweise auf der Ebene eines Zwischenmoduls, die relevanten Daten entweder direkt an das Einsteckmodul weiter und/oder er bereitet die ausgelesenen Daten für das Einsteckmodul auf.

Es ist weiterhin Bestandteil des erfindungsgemäßen Verfahrens, dass bei einem Neustart bzw. Hochfahren und/oder Programmstart des Hardwaresystems der Mastercontroller alle Slavecontroller bezüglich gesteckter und/oder aktivierter Einsteckmodule abfragt und eine Verbauliste erstellt, wobei die Verbauliste mit einer Sollverbauliste verglichen wird.

Bei Auftreten einer Differenz zwischen der Verbauliste und der Sollverbauliste wird weiterhin bevorzugt dann eine Fehlermeldung erzeugt. Im Rahmen der Erfindung ist es möglich die Sollverbauliste automatisch durch eine Initialisierung des Hardwaresystems bei Erstinbetriebnahme oder aber Wiederinbetiebnahme vorzunehmen oder die Sollverbauliste ebenfalls manuell zu editieren. Der Vergleich der Sollverbauliste mit der Verbauliste, also der Istverbauliste kann ebenfalls während des Betriebs des Hardwaresystems in zeitlichen Abständen durchgeführt werden, insbesondere in zyklischen Abständen. Diese Abstände sind dabei frei programmierbar beispielsweise in zeitlichen Intervallen. Somit kann das Hardwaresystem direkt feststellen, ob beispielsweise ein Teilnehmer des Hardwaresystems, also ein Einsteckmodul einen Fehler aufweist oder sich in einem nichtbetriebsfähigen Zustand befindet. Aufgrund der internen Kommunikation des Hardwaresystems über den systemeigenen Bus ist es jedoch wiederum möglich, dass das Hardwaresystem bei Auftreten eines Fehleis einer einzelne Komponente unbeschadet weiterbetrieben wird. Ebenfalls ist es aufgrund des systemeigenen Busses des Hardwaresystems möglich das bei Ausfallen eines Slavecontrollers einer Zusatzplatine eines Zwischenmoduls die Ansteuerung der in das Zwischenmodul eingesteckten Einsteckmodule über den Slavecontroller einer anderen Zusatzplatine anzusteuern oder aber auch über den Mastercontroller die Einsteckmodule direkt anzusteuern. Weiterhin vorzugsweise weist jedes Einsteckmodul einen eigenen Mikrocontroller auf, wobei der eigene Mikrocontroller des Einsteckmoduls dann jeweils ebenenintern mit einem Slavecontroller der Ebene kommuniziert, vorzugsweise über ein ebeneninternes Datenaustauschprotokoll, insbesondere über einen ebeneninternen Bus. Auch durch diese Verfahrensvariante ist es wiederum möglich die ausgetauschte Datenmenge innerhalb des gesamten Hardwaresystems gering zu halten, da durch den jeweiligen Slavecontroller einer Ebene oder aber durch den Mikroprozessor eines Einsteckmoduls eine weitere Datenaufbereitung erfolgen kann.

Der Slavecontroller kommuniziert mit dem Mastercontroller über den systemeigenen Bus, wobei die Daten des Mastercontrollers über das Display und/oder eine externe Dateneinrichtung ausgelesen und/oder von dem Display und/oder von einer externen Dateneinrichtung eingegeben werden. Somit ist es möglich das Hardwaresystem von einer externen Dateneinrichtung aus zu betreiben. Beispielsweise kann dies ein an das Hardwaresystem angeschlossener Computer sein. Auf Grund der Möglichkeit der Integration eines Eingabedisplays, insbesondere eines Touchdisplays in dem Gehäuse des Hardwaresystems ist jedoch auch ein autarker Betrieb des Hardwaresystems, ohne zusätzliche externe Eingabegeräte möglich.

Über den Mastercontroller ist es wiederum möglich eine Modelbildungssoftware insbesondere Matlab Simulink in das Hardwaresystem einzubinden. Hierüber ist es möglich, nahezu jede beliebige Modelumgebung zu simulieren, so dass verschiedenste Elektronik oder aber mechatronische Komponenten mit dem erfindungsgemäßen Hardwaresystem betrieben, überprüft, gemessen oder ausgelesen werden können. Insbesondere bietet sich die Erprobung von einzelnen Bauteilen für Kraftfahrzeuge an, dass über das Hardwaresystem mit eingebundener Modelbildungssoftware und eine hierüber implementierten Simulationsumgebung ermöglicht wird ein gesamtes Kraftfahrzeug mit allen elektronikbauteilen sowie dem kraftfahrzeugeigenen Datennetz zu simulieren.

Im Rahmen der Erfindung ist es jedoch insbesondere möglich über das erfindungsgemäße Verfahren zum Betreiben des Hardwaresystems alle Ebenen untereinander in harter Echtzeit zu betrieben. Ebenfalls kann selbst bei Anschluss von 50 oder mehr Einsteckmodulen über den erfindungsgemäßen Aufbau des Hardwaresystems sowie das damit verbundene Verfahren zum Betreiben des Hardwaresystems eine harte Echtzeitumgebung simuliert werden. Auf Grund des modularen Aufbaus sowie der Autoadressierung ist es möglich selbst hochkomplexe Prüfstandsaufbauten mit zahlreichen Anschlussmöglichkeiten einfach schnell und überschaubar herzustellen und zu Betreiben. Zeiten für aufwendige Prüfstandsaufbauten, insbesondere Rüstzeiten sowie Zeiten für Fehlersuchen und/oder zur Herstellung von Kompatibilität der einzelnen Prüfstandkomponenten untereinander entfallen mit dem erfindungsgemäßen Hardwaresystem gänzlich.

Das erfindungsgemäße Hardwaresystem zeichnet sich weiterhin durch eine Autoadressierungsmöglichkeit aus. Hierbei wird bei Neustart und/oder Reset oder aber bei Einstecken eines neuen Einsteckmoduls und/oder in sich wiederholenden zeitlichen Abständen eine Autoadressierung aller im System angeordneten Modulebenen und/oder Zwischenmodule und/oder Einsteckmodule durchgeführt, bevorzugt ausgehend von dem Grundmodul, insbesondere ausgehend von dem Mastercontroller des Grundmoduls und ganz besonders bevorzugt von dem ersten Einsteckmodul in dem Grundmodul und/oder von dem ersten auf das Grundmodul folgende Einsteckmodul. Bei dem ersten auf das Grundmodul folgenden Einsteckmodul handelt es sich bevorzugt um das Einsteckmodul, dass in dem dem Grundmodul benachbartem Zwischenmodul angeordnet ist. Im Rahmen der Erfindung ist es über den systemeigenen Bus vorstellbar, dass jeweils nur die Master- und Slavecontroller der jeweiligen Modulebenen zueinander autoadressiert sind.

Im Rahmen der Erfindung ist es jedoch auch vorstellbar, dass jedes Einsteckmodul über einen Mikrocontroller verfügt, und sich die einzelnen Mikrocontroller der Einsteckmodule seriell autoadressieren. Hierzu muss jeder Mikrocontroller eine individuelle Nummer besitzen, um im Betrieb des Hardwaresystems individuell ansprechbar zu sein. Mikrocontroller 1 sendet somit ein Resetsignal an den Mikrocontroller 2, welcher sich daraufhin neu bootet. Der Mikrocontroller 2 sendet ein Resetsignal an Mikrocontroller 3, der sich daraufhin neu bootet und ein Resetsignal an Mikrocontroller 4 sendet, was sich bis zu der Anzahl der angeschlossenen Mikrocontroller an das Hardwaresystem fortsetzt.

Bevorzugt wird bei dem erfindungsgemäßen Hardwaresystem die Autoadressierung derart ausgeführt, dass der erste Mikrocontroller seine Empfängerleitung mit der Senderleitung vertauscht, so dass die Senderleitung zu der Empfängerleitung und die Empfängerleitung zur Senderleitung wird. Auf dieser Leitung wird dann eine Kennung an den zweiten Mikrocontroller gesendet, wobei danach der erste Mikrocontroller seinen ursprünglichen Zustand wiederherstellt. Der zweite Mikrocontroller vertauscht daraufhin wiederum seine Senderleitung mit seiner Empfängerleitung und sendet die Kennung um +1 erhöht an den dritten Mikrocontroller und stellt im Anschluss hieran seinen Ursprungszustand wieder her.

Damit eine serielle Schaltung der einzelnen Mikrocontrollerebenen übergreifend herstellbar ist, ist eine lösbare Steckverbindung der einzelnen Modulebenen untereinander mit einem versetzten Pin gekoppelt. Die Verbindung der Resetleitung der einzelnen Ebenen untereinander weist somit einen Pinversatz auf, so dass die einzelnen Modulebenen faktisch in Reihe geschaltet sind.

Im Rahmen der Erfindung ist dann jedes Einsteckmodul zentral von dem Mastercontroller aus über den systemeigenen Bus ansteuerbar. Ebenfalls ist es im Rahmen der Erfindung möglich das Einsteckmodul dezentral über jeweils einen Slavecontroller aus anzusteuern. Je nach aktueller Betriebsart, auszutauschender Datenmenge und Anforderung an die Echtzeitfähigkeit ist somit eine flexible Regelungs- und Steuerungsmöglichkeit des Hardwaresystems selbst mit einer Vielzahl angeschlossenen externen Elementen möglich. Auch ist ein paralleler Betrieb möglich, wobei der Mastercontroller direkt auf einzelne Einsteckmodule zugreift und andere Einsteckmodule indirekt über die jeweiligen Slavecontroller der Zwischenmodule anspricht.

Weiterhin sind besonders bevorzugt zwei oder mehr Einsteckmodule in einem Zwischenmodul zentral von einem in dem Zwischenmodul befindlichen Slavecontroller aus ansteuerbar. Auch hierdurch wird wiederum eine Filterungsfunktion der jeweiligen auf der Modulebene angeordneten Einsteckmodule vorgenommen. Die auszutauschenden Datenmengen der einzelnen Modulebenen untereinander werden hierdurch reduziert, weshalb es mit dem erfindungsgemäßen Hardwaresystem möglich ist selbst eine Vielzahl von in Reihe geschalteten Zwischenmodulen in harter Echtzeitumgebung zu betreiben.

Weiterhin besonders bevorzugt ist der Slavecontroller als Mikroprozessor ausgebildet, vorzugsweise ist der Slavecontroller durch zwei spiegelsymetrische auf der Zusatzplatine angeordnete Mikroprozessoren ausgebildet. Die Zusatzplatine selber ist dabei als Modulplatine des Zwischenmoduls ausgebildet und weist zusätzliche elektronische Bausteine beispielsweise in Form von Prozessoren oder Speichereinheiten auf. Durch den spiegelsymetrischen Aufbau des Slavecontrollers auf der Zusatzplatine des Zwischenmoduls wird wiederum ein redundanter ebeneninterner Betrieb ermöglicht. Für bestimme insbesondere sicherheitsrelevante Anwendungen kann ein redundanter Betrieb notwendig sein, so dass bei Ausfall eines der zwei spiegelsymetrischen Mikroprozessoren der andere Mikroprozessor die modulebeneninterne Kommunikation und somit die Ansteuerung der in das Modul eingesteckten Einsteckmodule übernimmt.

Zur Autoadressierung selber weist jedes Einsteckmodul einen Speicherbaustein auf, auf dem eine Einsteckmodulkennung gespeichert ist. Vorzugsweise handelt es sich dabei um einen EEPROM.

Die zuvor genannten Eigenschaften bzw. Merkmale sind im Rahmen der Erfindung beliebig untereinander kombinierbar mit den sich damit ergebenden Vorteilen, ohne den Rahmen der Erfindung zu verlassen.

Weitere Vorteile, Merkmale, Eigenschaften und Aspekte der vorliegenden Erfindung sind Bestandteil der folgenden Beschreibung. Bevorzugte Ausführungsvarianten werden in den schematischen Figuren dargestellt. Diese dienen dem einfachen Verständnis der Erfindung. Es zeigen:
- Figur 1: ein erfindungsgemäßes Hardwaresystem mit Zwischenmodul in Explosivdarstellung;
- Figur 2a und b: das Hardwaresystem in Zusammenbauweise;
- Figur 3a bis d: das Deckelmodul in verschiedenen Ansichten;
- Figur 4a bis d: das Zwischenmodul in verschiedenen Ansichten;
- Figur 5a bis d: das Grundmodul in verschiedenen Ansichten;
- Figur 6a und b: die Zwischenschicht in verschiedenen Ansichten;
- Figur 7a bis d: das Einsteckmodul in verschiedenen Ansichten;
- Figur 8: die zentrale Spannungsversorgung;
- Figur 9: eine Spannungsverteilung in einem Zwischenmodul;
- Figur 10: eine Datenkommunikation zwischen einem Modul, Einsteckmodul und einem an das Einsteckmodul angeschlossenen externen Element;
- Figur 11: einen spiegelsymmetrischen Aufbau eines Zwischenmoduls mit vier Einsteckmodulen;
- Figur 12: ein Schema der Autoadressierung;
- Figur 13: eine schematische Darstellung des Pfostenfeldsteckers der einzelnen Modulebenen;
- Figur 14: eine Autoadressierung auf einer Modulebene und
- Figur 15: eine Elektronikplatine zur Anordnung in einem erfindungsgemäßen Gehäuse.

In den Figuren werden für gleiche oder ähnliche Bauteile aus Vereinfachungsgründen dieselben Bezugszeichen verwendet, auch wenn eine wiederholte Beschreibung aus Vereinfachungsgründen entfällt.

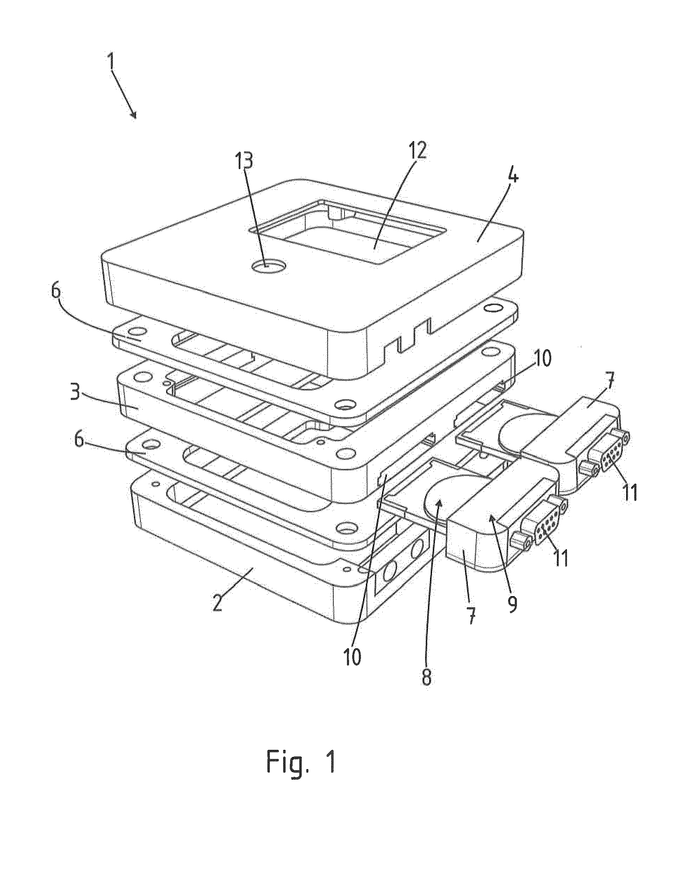

Figur 1 zeigt das erfindungsgemäße modular konfigurierbare Hardwaresystem 1 in einer Explosivdarstellung. Das Hardwaresystem 1 weist ein Grundmodul 2, ein Zwischenmodul 3 sowie ein Deckelmodul 4 auf. Im Rahmen der Erfindung ist es möglich, zwei, drei, vier oder aber beliebig viele, technisch sinnvolle, Zwischenmodule 3 zwischen dem Grundmodul 2 und dem Deckelmodul 4 anzuordnen. So ist es beispielsweise im Rahmen der Erfindung möglich, bis zu 50 oder sogar 60 Zwischenmodule 3 zwischen Grundmodul 2 und Deckelmodul 4 anzuordnen. In der Regel sollten als Haupteinsatzzweck zwischen zwei und elf Zwischenmodule 3 zwischen dem Grundmodul 2 und dem Deckelmodul 4 angeordnet werden. Die einzelnen Module 2, 3, 4 bilden dabei jeweils eine Modulebene 5. Die einzelnen Modulebenen 5 sind untereinander von einer jeweiligen Zwischenschicht 6 getrennt. Bei der Zwischenschicht 6 kann es sich dabei um eine Isolierungsschicht oder aber auch eine Zwischenschicht 6 aus einem metallischen Material handeln.

In das Hardwaresystem 1 sind weiterhin Einsteckmodule 7 lösbar einsteckbar. Die Einsteckmodule 7 weisen selber wiederum einen Kartenabschnitt 8 sowie einen Modulabschnitt 9 auf. Der Kartenabschnitt 8 ist dabei vollständig in eine Einstecköffnung 10 des Hardwaresystems 1, hier dargestellt in eine Einstecköffnung 10 des Zwischenmoduls 3, einsteckbar. Der Modulabschnitt 9 des Einsteckmoduls 7 steht dann gegenüber dem Hardwaresystem 1 über. Jedes Einsteckmodul 7 weist wiederum einen Stecker 11 auf, an dem dann, hier nicht näher dargestellte Sensoren, Aktoren oder aber auch Datennetze ansteckbar sind.

Das Deckelmodul 4 des Hardwaresystems 1 weist ferner ein Display 12 auf, über das Bestdatenbetriebszustände oder sonstige Informationen anzeigbar sind. Ferner ist das Display 12 als Touchdisplay ausgebildet, so dass sich das Hardwaresystem 1 auch über das Display 12 selbst bedienen lässt. In dem Deckelmodul 4 ist weiterhin ein zentraler Taster 13 angeordnet, dessen Funktion im Rahmen der Erfindung wiederum frei programmierbar ist. Es bietet sich an, den zentralen Taster 13 für einen Powerdownmodus, also einen Taster 13, um das Hardwaresystem, 1 in einen Bereitschaftszustand oder aber in einen Sleepzustand zu versetzen.

Nachfolgende Figuren sind nicht maßstabsgetreu. Das Hardwaresystem kann quadratisch oder auch rechteckförmig konfiguriert sein.

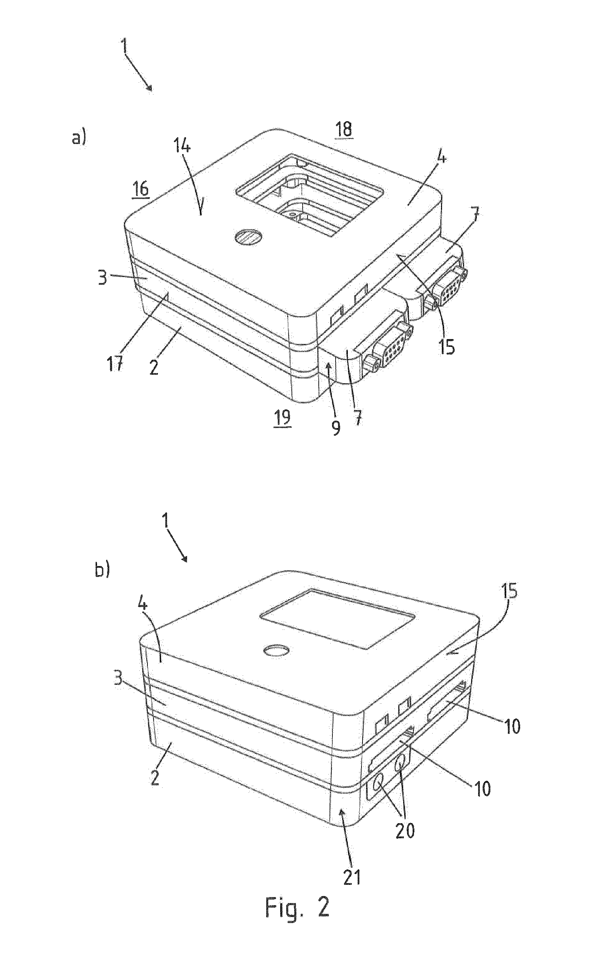

Figur 2a und b zeigen das erfindungsgemäße Hardwaresystem 1 in Zusammenbauweise, ebenfalls bestehend aus einem Grundmodul 2, Zwischenmodul 3 sowie einem Deckelmodul 4. Zwischen den einzelnen Modulen sind wiederum Zwischenschichten 6 angeordnet, die eine Trennung der Modulebenen 5 untereinander ermöglichen. Gut zu erkennen ist, dass das Hardwaresystem 1 eine kastenförmige Konfiguration aufweist. Die Oberseite 14 wird dabei von dem Deckelmodul 4 gebildet. Ebenfalls in Figur 2a ist dargestellt, dass die Einsteckmodule 7 in das Zwischenmodul 3 an einer vorderen Einsteckseite 15 nebeneinander eingesteckt sind. An einer nicht näher dargestellten hinteren Einsteckseite 16 ist es ebenfalls möglich, zwei Einsteckmodule 7 in das Zwischenmodul 3 einzustecken. Demgegenüber verbleiben eine auf die Bildebene bezogene vordere Seitenwand 17 sowie eine hintere Seitenwand 18. Die Seitenwände 17, 18 selber sowie die Einsteckseiten 15, 16 bilden dabei die seitlichen Wände des Gehäuses. Die Oberseite 14 wird durch das Deckelmodul 4 mit ausgebildet sowie die nicht näher dargestellte Unterseite 19 durch das Grundmodul 2. Die Einsteckmodule 7 selbst kommen dabei mit dem Modulabschnitt 9 an der vorderen Einsteckseite15 zur Anlage. Der Modulabschnitt 9 selber steht gegenüber der vorderen Einsteckseite 15 über. Das Hardwaresystem in Figur 2a ist ohne elektronisches Innenleben, also nur als leeres Gehäuse dargestellt.

In Figur 2b dargestellt ist das zusammengebaute Hardwaresystem 1 ohne Einsteckmodule 7. Zu erkennen sind die zwei Einsteckschächte 10 in der vorderen Einsteckseite 15 auf Höhe des Zwischenmoduls 3. Ebenfalls zu erkennen ist ein Spannungsanschluss 20 in dem Grundmodul 2 zum Anschluss von hier nicht näher dargestellten Spannungsversorgungsleitungen. Ferner weist die kastenförmige Gehäusekonfiguration abgerundete Ecken 21 auf, die einen Übergang von der vorderen Einsteckseite 15 zu der hinteren Seitenwand 18 und von der hinteren Seitenwand 18 zu der hinteren Einsteckseite 16 ermöglichen. Hierdurch wird die Handhabung des Hardwaresystems 1 vereinfacht sowie das Verletzungsrisiko eines Bedieners verringert.

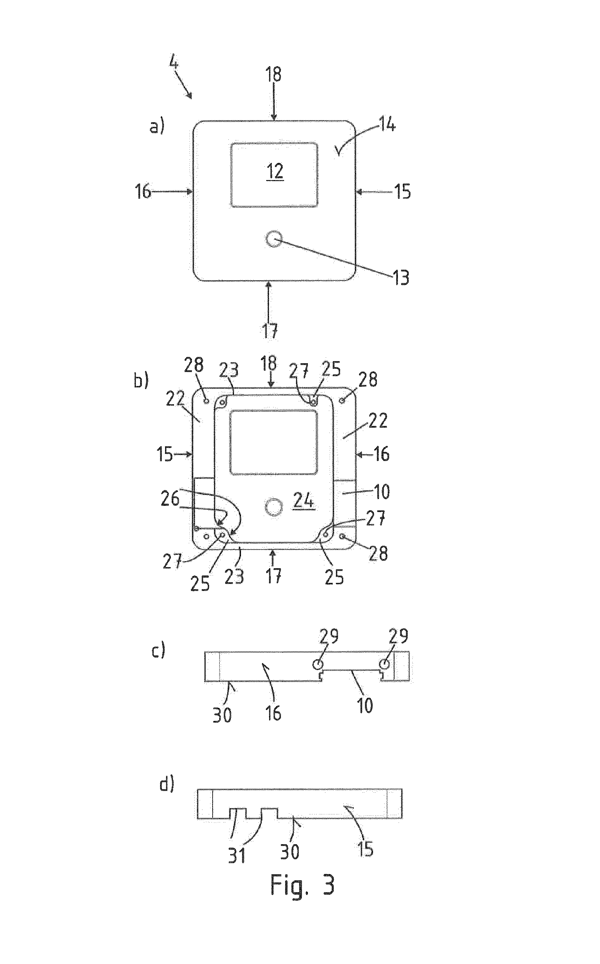

Figur 3a bis d zeigen ein Deckelmodul 4 in einer Draufsicht, Unteransicht sowie einer jeweiligen Seitenansicht der vorderen 15 und hinteren Einsteckseite 16. In Figur 3a ist eine Draufsicht auf die Oberseite 14 des Deckelmoduls 4 gezeigt. Das Deckelmodul 4 weist eine im Wesentlichen quadratische Konfiguration auf, wobei in die Oberseite 14 das Display 12 sowie ein Taster 13 eingelassen sind.

In Figur 3b ist dargestellt, dass an der vorderen Einsteckseite 15 sowie an der hinteren Einsteckseite 16 eine jeweils dickere Gehäusewandung 22 ausgebildet ist, in Relation zu der Gehäusewandung 23 der vorderen 17 und hinteren Seitenwand 18. Im Inneren des Deckelmoduls 4 ist eine Ausnehmung 24 ausgebildet, sodass das Deckelmodul 4 von innen hohl ist. Es ist somit möglich, eine nicht näher dargestellte Platine in dem Deckelmodul 4 mit entsprechend auf der Platine angeordneten Elektronikkomponenten zu platzieren.

Weiterhin sind in der Ausnehmung 24 Montagesockel 25 vorhanden, wobei die Montagesockel 25 dazu dienen, die nicht näher dargestellte Platine aufzunehmen. Die dargestellten Rundungen 26 bzw. Radien entstehen durch eine Herstellung des Deckelmoduls 4 in Fräsbauweise. Hierdurch wird es ermöglicht, den zur Verfügung stehenden Bauraum optimal auszunutzen, bei gleichzeitiger günstiger Herstellung durch Verwendung entsprechender spanabhebender Fräsmittel. In den Montagesockeln 25 sind Montagelöcher 27 angeordnet, so dass die nicht näher dargestellte Platine in den Montagelöchern 27 steckbar und/oder schraubbar ist. Ferner sind in den Gehäusewandungen 22, 23 ebenfalls Montagelöcher 28 angeordnet, mit denen es möglich ist, die einzelnen Modulebenen 5 miteinander zu koppeln.

Figur 3c zeigt eine Ansicht der hinteren Einsteckseite 16, wobei, wie hier dargestellt, ein Einsteckschacht in dem Deckelmodul 4 angeordnet ist. Auf die Bildebene bezogen oberhalb des Einsteckschachtes 10 sind Magnete 29 angeordnet, wobei die Magnete 29 dazu dienen, mit dem hier nicht näher dargestellten Magneten eines Einsteckmoduls 7 eine formschlüssige magnetische Verbindung herzustellen. Hierdurch wird sichergestellt, dass das Einsteckmodul 7 lösbar ordnungsgemäß in den Einsteckschacht eingesteckt wird und durch die magnetische Verbindung gehalten wird und das beim Einstecken entstehende Klackgeräusch dem Bediener dieses auch zu erkennen gibt. Das eingesteckte Einsteckmodul 7 wird durch die magnetische Verbindung arretiert, so dass es nicht unbeabsichtigt bzw. ungewollt aus dem Gehäuse entfernt wird bzw. aus diesem herausfällt.

Ferner ist der Einsteckschacht 10 durchgängig auf die Oberfläche der Montageunterseite 30 des Deckelmoduls 4 ausgebildet. Dies bedingt eine besonders kostengünstige Fertigungsmöglichkeit, da mit einem spanabhebenden Fräswerkzeug direkt der Einsteckschacht 10 mit ausgebildet werden kann.

Figur 3d zeigt die vordere Einsteckseite 15 des Deckelmoduls 4, wobei hier zwei Stecköffnungen 31 angeordnet sind, wobei nur die Stecköffnungen 31 weitere, nicht näher dargestellte oder beschriebene Steckverbindungen einsteckbar sind.

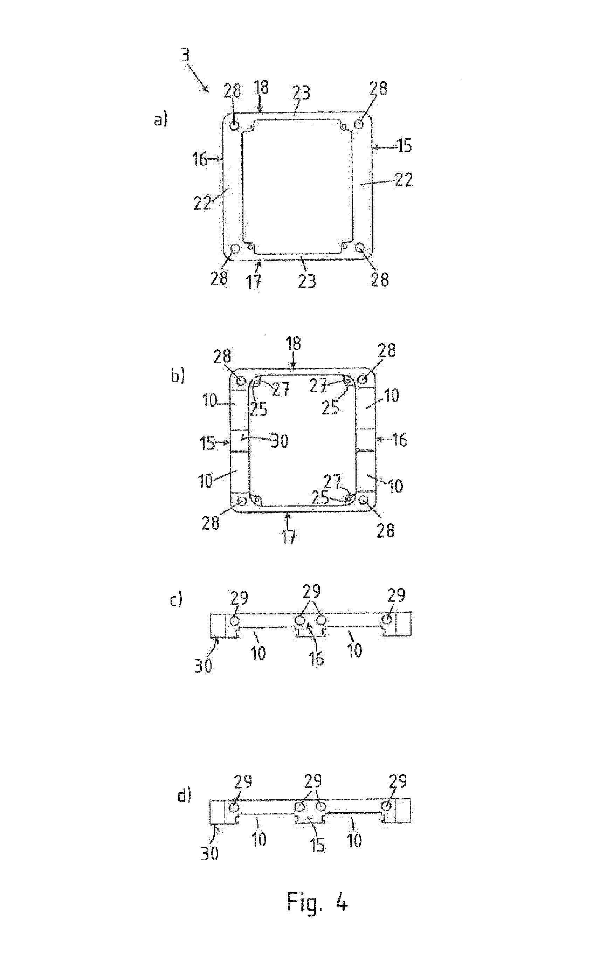

Figur 4a bis d zeigen weiterhin eine Draufsicht, eine Hinteransicht sowie jeweils eine Seitenansicht der vorderen Einsteckseite 15 und der hinteren Einsteckseite 16 eines Zwischenmoduls 3. Auch bei dem Zwischenmodul 3 ist gemäß Figur 4a und b zu erkennen, dass die Gehäusewandung 22 der vorderen Einsteckseite 15 und der hinteren Einsteckseite 16 größer ausgebildet ist, als die Gehäusewandung 23 der vorderen Seitenwand 17 und der hinteren Seitenwand 18. Insbesondere im Bereich der Einsteckschächte 10 bietet die breitere Gehäusewandung 22 der vorderen Einsteckseite 15 sowie der hinteren Einsteckseite 16 eine bessere Abstützmöglichkeit für die hier nicht näher dargestellten Einsteckmodule 7. Der nicht näher dargestellte Kartenabschnitt 8 des Einsteckmoduls 7 wird durch die breite Gehäusewand 22 der vorderen Einsteckseite 15 und/oder der hinteren Einsteckseite 16 abgestützt.

Das Zwischenmodul 3 ist im Inneren vollständig ausgehüllt. Auch hier kann wiederum eine nicht näher dargestellte Elektronikplatine angeordnet werden. Dazu weist das Zwischenmodul 3 ebenfalls Montagesockel 25 auf, wobei die Montagesockel 25 ebenfalls Montagelöcher 27 aufweisen, um die nicht näher dargestellte Elektronikplatine festzuschrauben. Weiterhin sind Montagelöcher 28 in den Ecken der Gehäusewandungen 22, 23 dargestellt, so dass mehrere Zwischenmodule 3 bzw. das Deckelmodul 4 und/oder das Grundmodul 2 an dem Zwischenmodul 3 steckbar und/oder verschraubbar sind.

Weiterhin ersichtlich ist in Figur 4c und d, die jeweils die vordere Einsteckseite 15 bzw. hintere Einsteckseite 16 darstellen, dass das Zwischenmodul 3 spiegelsymmetrisch aufgebaut ist. Hierdurch wird es ermöglicht, vier Einsteckmodule 7 in ein Zwischenmodul 3 einzustecken. Auch sind die Einsteckschächte 10 in dem Zwischenmodul 3 derart ausgebildet, dass sie in eine Montageunterseite 30 des Zwischenmoduls 3 übergehen. Auch hierdurch ergibt sich wiederum der Vorteil einer besonders kostengünstigen Fertigung. Auch sind an der vorderen Einsteckseite 15 und an der hinteren Einsteckseite 16 Magnete 29 angeordnet, wobei die Magnete 29 wiederum mit an den hier nicht näher dargestellten Einsteckmodulen 7 angeordneten Magneten eine formschlüssige magnetische Verbindung eingehen.

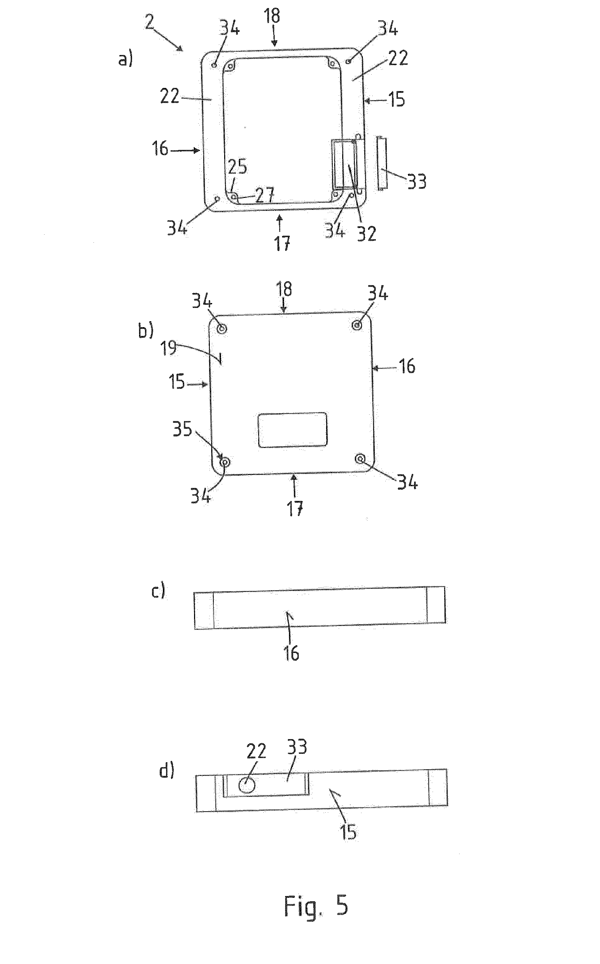

Weiterhin dargestellt sind in Figur 5a bis d eine Draufsicht, eine Unteransicht sowie eine Ansicht der vorderen Einsteckseite 15 und der hinteren Einsteckseite 16 des Grundmoduls 2.

Figur 5a zeigt eine Draufsicht auf das Grundmodul 2, wobei auch hier die Gehäusewandung 22 der vorderen Einsteckseite 15 und der hinteren Einsteckseite 16 gegenüber der Gehäusewandung 23 der vorderen Seitenwand 17 und der hinteren Seitenwand 18 dicker ausgebildet ist. Weiterhin dargestellt ist eine Öffnung 32 für den Spannungsanschluss 20, wobei in die Öffnung 32 ein Adapterstück 33 einsetzbar ist. Das Grundmodul 2 weist die Unterseite 19 des Hardwaresystems 1 gemäß Figur 5b auf. Eingezeichnet sind hier vier Schraubverbindungen 34, die es ermöglichen, das gesamte Hardwaresystem 1 miteinander zu koppeln. Ebenfalls kann im Bereich der Schraubverbindung 34 jeweils ein Fuß 35 angeordnet sein, welcher beispielsweise ein Gummifuß sein kann, sodass das Hardwaresystem 1 sicher und rutschfest auf einen Untergrund stellbar ist. Weiterhin sind in Figur 5a ebenfalls Montagesockel 25 zur Anordnung eine nicht näher dargestellten Grundplatine im Inneren des Grundmoduls vorgesehen. Auch die Montagesockel 25 weisen wiederum Montagelöcher 25 zur Kopplung der Grundplatine mit dem Grundmodul 2 auf. Die Grundplatine kann im Rahmen der Erfindung auch in dem Deckelmodul 4 angeordnet werden, so dass durch das Grundmodul 2 eine Spannungsversorgung des Hardwaresystems 1 hergestellt wird.

Figur 5c und d zeigen jeweils eine Seitenansicht, wobei in Figur 5d eine Seitenansicht der vorderen Einsteckseite 15 und der hinteren Einsteckseite 16, in Figur 5c gezeigt ist. In Figur 5d ist das Adapterstück 33 in der Öffnung 20 angeordnet ist und das Adapterstück 33 weist einen Spannungsanschluss 20 auf. In der Regel sind dies 12 Volt.

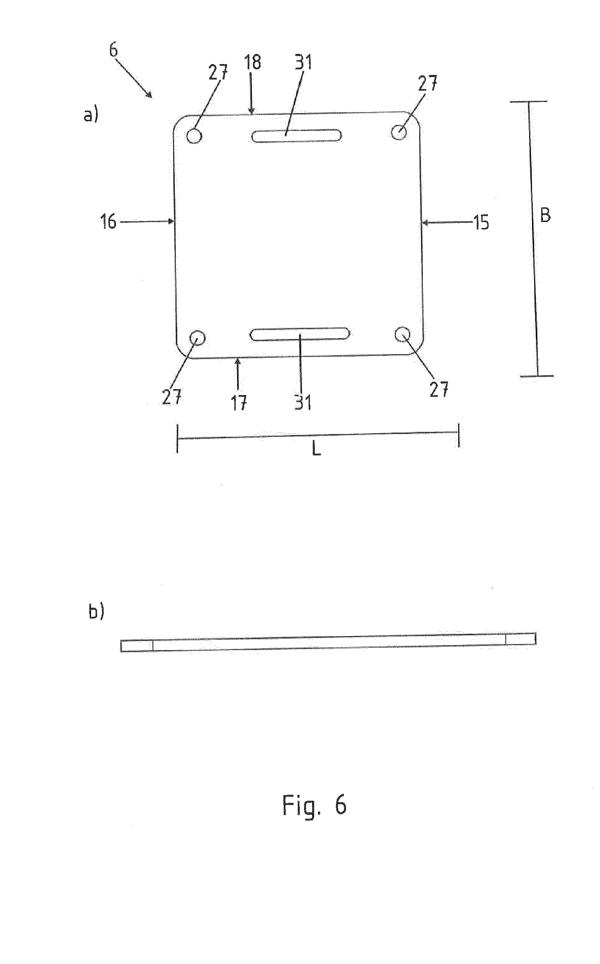

In Figur 6a und b ist eine Zwischenschicht 6 in einer Draufsicht sowie in einer Seitenansicht gezeigt. Die Zwischenschicht 6 dient als Isolator und/oder Abstandhalter zwischen den einzustellenden Modulen. Auch die Zwischenschicht 6 weist Montagelöcher 27 zur Durchführung hier nicht näher dargestellter Montagemittel, die zur Kopplung der einzelnen Module eingesetzt werden, auf. In der hier gezeigten Ausführungsvariante ist die Zwischenschicht 6 massiv ausgebildet, d. h. sie schottet die einzelnen Modulebenen 5 voneinander physisch ab.

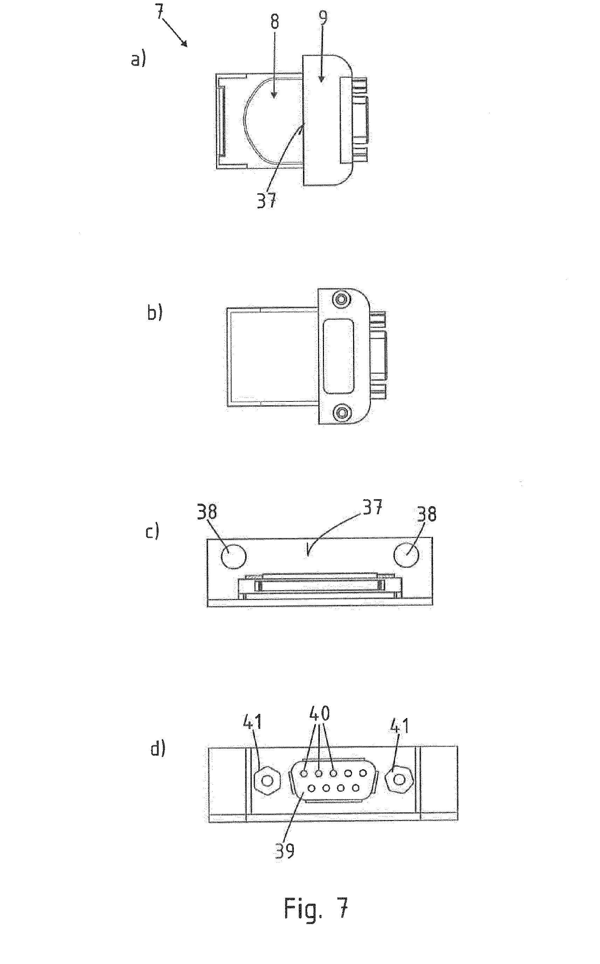

Damit die Platinen der jeweiligen Module miteinander kommunizieren können, sowie mit Strom versorgt werden, weist die Zwischenschicht 6 Steckeröffnungen 31 auf, wobei durch die Steckeröffnungen 31 mehrpolige Pfostenfeldstecker 65 zum Datenaustausch und/oder zur Spannungsversorgung der einzelnen Platinen der Module ausgebildet sind. Die Steckeröffnungen 31 sind dabei im Bereich der Gehäusewandung 23 der vorderen Seitenwand 17 sowie der hinteren Seitwand 18 angeordnet. Die hier nicht näher dargestellten Pfostenfeldstecker 65 ermöglichen es also, die Einsteckmodule 7 mit dem Kartenabschnitt jeweils vollständig in das Modul einzuführen und somit an den nicht näher dargestellten Pfostenfeldsteckern 65 vorbeizuführen. Die Zwischenschicht 6 ist in ihrer Länge L und Breite B den einzelnen Modulen der Figuren 3, 4 und 5 entsprechend ausgebildet. Insbesondere in der Länge L ist es jedoch möglich, dass die Zwischenschicht 6 gegenüber den Modulen übersteht, so dass sie auch den Modulabschnitt des Einsteckmoduls 7 zumindest teilweise überdeckt. Figur 7a bis d zeigen ein Einsteckmodul 7 in einer Draufsicht, in einer Unteransicht sowie in einer Vorder- und einer Rückansicht. In Figur 7a und b ist die Einteilung des Einsteckmoduls 7 ein Kartenabschnitt 8 und Modulabschnitt 9 zu erkennen. Der Kartenabschnitt 8 wird dabei vollständig in das nicht näher dargestellte Hardwaresystem 1 eingesteckt, so dass der Modulabschnitt 9 formschlüssig mit einer Anlagefläche 37 an der vorderen 15 bzw. hinteren Einsteckseite 16 des Hardwaresystems 1 zur Anlage kommt.

Im Modulabschnitt 9 selber ist dann eine entsprechende Hardware für den Anschluss eines nicht näher dargestellten externen Elements, beispielsweise eines Senors oder aber auch eines Aktors unterbringbar. Hierdurch ergibt sich erfindungsgemäß der Vorteil, dass ein Wärmeeintrag in das Hardwaresystem 1 selber vermieden wird, da die elektrischen Bauteile außerhalb des Hardwaresystemsm 1 selber untergebracht sind.

In Figur 7c ist dargestellt, dass der Modulabschnitt mit einer Anlagefläche 37 an dem Hardwaresystem 1, genauer an der vorderen Einsteckseite 15 oder an der hinteren Einsteckseite 16 zur Anlage kommt. In die Anlagefläche 37 eingelassen sind Einsteckmodulmagneten 38, die mit dem Magneten 29 des Hardwaresystems 1 eine magnetische Verbindung eingehen und somit ein vollständiges Einrasten sowie einen festen Sitz der Einsteckmodule 7 in dem Hardwaresystem 1 sicherstellen.

In Figur 7d ist eine mögliche Anschlussmöglichkeit eines nicht näher dargestellten Sensors, Aktors oder Ähnlichem an das Einsteckmodul 7 in Form eines D-Sub-Steckers 39 dargestellt. Der D-Sub-Stecker 39 selber besteht dabei aus neun Polen 40 sowie zwei Sicherungsschrauben 41. Im Rahmen der Erfindung ist es aber beispielsweise auch vorstellbar, andere Steckverbindungen einzusetzen, beispielsweise Ethernetsteckverbindungen oder aber auch nur einen zweipoligen Stecker.

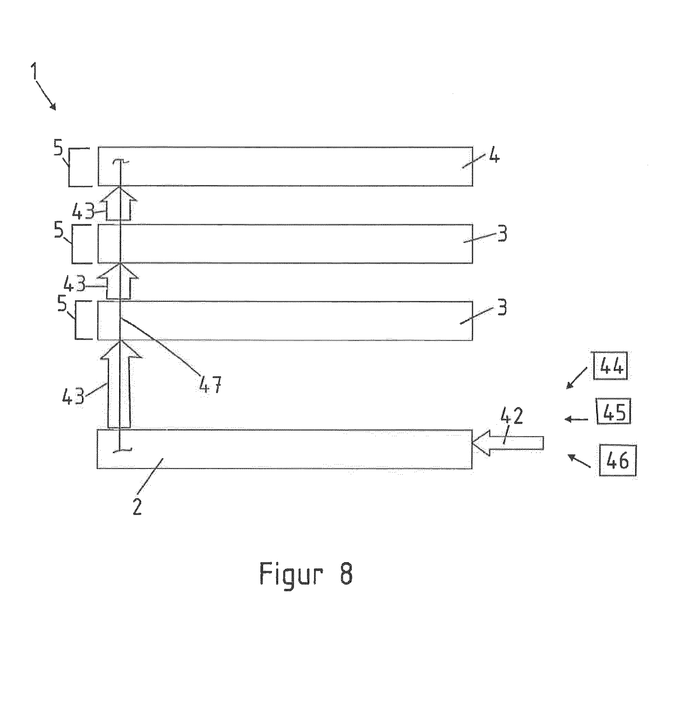

Figur 8 zeigt die Spannungsversorgung des Hardwaresystems 1, wobei hier dargestellt eine externe Versorgungsspannung 42 in das Grundmodul 2 beigebracht wird, und die externe Versorgungsspannung 42 von dem Grundmodul 2 aus auf die einzelnen Modulebenen 5 weitergeleitet wird. Die externe Versorgungsspannung 42 wird also von dem Grundmodul 2 als interne Versorgungsspannung 43 direkt weitergeleitet. Bevorzugt ist die externe Versorgungsspannung 42 gleich der internen Versorgungsspannung 43 gleich im Wesentlichen 12 Volt. Der Aufbau des Hardwaresystems 1 kann in der in Figur 8 dargestellten Konfiguration derart ausgebildet sein, dass das Deckelmodul 4 als Master fungiert und die Zwischenmodule 3 als Slave. Das Grundmodul 2 hat dann eine ausschließlich abschließende Funktion des Gehäuses sowie eine Weiterleitung der Versorgungsspannung 42.

Die Versorgungsspannung selber kann von einem Netzteil 44, von einem Akkumulator 45 oder aber auch von einem Kraftfahrzeugbordnetz 46 in das Grundmodul 2 eingespeist werden. Ebenfalls ist es vorstellbar, dass das Grundmodul 2 selber als Akkumulator 45 ausgebildet ist, also im Inneren des Grundmoduls 2 ein entsprechender Akkumulator 45 bzw. Akkumulatorzellen angeordnet sind. Im Rahmen der Erfindung verfügt das Hardwaresystem 1 über eine modular erweiterbare, physisch direkt gekoppelte Versorgungsleitung 47, die durch das gesamte Hardwaresystem 1 ausgebildet ist. Die Versorgungsleitung 47 ist mindesten einadrig, bevorzugt zwei- oder aber auch dreiadrig ausgebildet. Ebenfalls ist es im Rahmen der Erfindung vorstellbar, die Versorgungsleitung 47 redundant spiegelsymmetrisch bzw. mit einem nicht näher dargestellten Pfostenfeldstecker 65 ebenfalls redundant auszubilden. Das Hardwaresystem 1 verfügt somit über eine zentrale Spannungsversorgung.

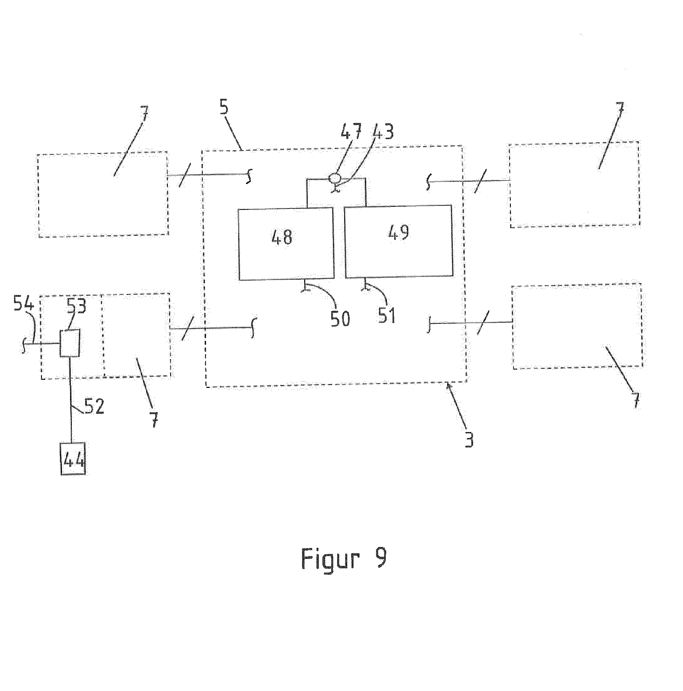

Figur 9 zeigt die Spannungsverteilung in einem Zwischenmodul 3. Hier ist zum einen die interne Versorgungsspannung 43 direkt von der Versorgungsleitung 47 abgreifbar und auf dem Modul direkt als interne Versorgungsspannung 43 weiterleitbar. Die interne Versorgungsspannung 43 ist jedoch auch im Rahmen der Erfindung von der Versorgungsleitung 47 abgreifbar und an einen jeweiligen Spannungswandler weiterleitbar. Hier dargestellt sind bevorzugt ein Spannungswandler 48, der eine Spannung 50 von 5 Volt und ein Spannungswandler 49, der eine Spannung 51 von 3,3 Volt wandelt. Von den Spannungswandlern 48, 49 sind dann Modulebenenspannungen in Höhe von 5 Volt 50 und Modulebenenspannungen in Höhe von 3,3 Volt 51 abgreifbar. Die drei verschiedenen Spannungsarten, also die interne Versorgungsspannung 43, die Modulebenenspannungen 5 Volt 50 und die Modulebenenspannungen 3,3 Volt 51 sind dann von jedem Einsteckmodul 7 auf der Modulebene 5 abgreifbar bzw. an das jeweilige Einsteckmodul 7 weiterleitbar. Bei den Spannungswandlern 48, 49 handelt es sich bevorzugt um getaktete Spannungsregler, um den Wärmeeintrag in dem System auch bei hoher Anzahl von Modulebenen 5 so gering wie möglich zu halten. Die Spannungswandler 48, 49 sind derart ausgelegt, dass sie eine Modulebene 5 mit vier Einsteckmodulen 7 und ausreichender Reserve mit der benötigten Spannung versorgen können.

Im Rahmen der Erfindung ist es weiterhin vorstellbar, dass insbesondere höhere Lastströme 54 geschaltet werden müssen. Bei Aktoren, die selbst nicht von einer externen Spannungsquelle, sondern von der Regelungs- bzw. Steuerungseinheit mit Spannung versorgt wird, ist dies insbesondere erforderlich. Hierbei wird wiederum von einem entsprechenden Netzteil 44, welches das gleiche Netzteil 44 der Versorgungsspannung 43 des Hardwaresystems 1 oder aber auch ein hiervon verschiedenes Netzteil sein kann, eine Lastversorgungsspannung 52 abgreifbar, die dann durch einen Leistungstreiber 53 derart geregelt wird, dass ein Laststrom 54 an ein hier nicht näher dargestelltes externes Element 58, beispielsweise einen Motortreiber, weitergegeben wird. Da sich der Leistungstreiber 53 selbst wiederum nicht innerhalb des Hardwaresystems 1 befindet, sondern bevorzugt in dem Einsteckmodul 7, erfolgt somit auch kein Wärmeeintrag in das Hardwaresystem 1 selber.

Durch die in Figur 8 und Figur 9 gezeigte zentrale Spannungsversorgung ist es somit möglich, eine zentrale interne Versorgungsspannung 43 innerhalb der Ebenen weiterzugeben. Auf einer jeweiligen Modulebene 5 wird die interne Versorgungsspannung 43 über mindestens einen getakteten Spannungswandler 48, 49 entsprechend in eine dort benötigte Spannung gewandelt. Ebenfalls ist es möglich, auf der Modulebene 5 die interne Versorgungsspannung 43 direkt abzugreifen. Über die so bereitgestellten verschiedenen Spannungen auf der Modulebene 5 ist es möglich, die diskreten Bausteine sowie die Einsteckmodule 7 und deren Bausteine mit Spannung zu versorgen. Durch diese dezentrale Anordnung der einzelnen Spannungswandler 48, 49 pro Ebene ist es erfindungsgemäß möglich, das Hardwaresystem 1 beliebig modular zu erweitern, also zu konfigurieren. Insbesondere ist es möglich, ohne Modifikation einer zentralen Spannungsversorgung sowie einer Erhöhung der Redundanz das Hardwaresystem 1 beliebig wachsen zu lassen, da die jeweilige Redundanz bzw. Spannungsversorgung auf einer Modulebene 5 erfolgt.

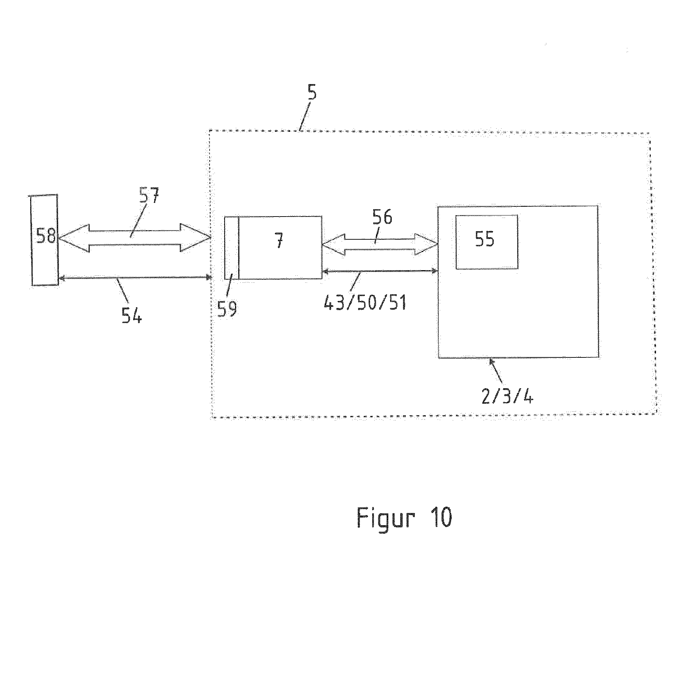

Figur 10 zeigt die Datenkommunikation sowie die Spannungsversorgung auf einer jeweiligen Modulebene 5. Hierbei ist das Grundmodul 2 oder das Zwischenmodul 3 oder das Deckelmodul 4 mit einem Controller 55 ausgestattet, der je nach Konfiguration des Hardwaresystems 1 ein Mastercontroller oder aber ein Slavecontroller sein kann. Der Controller 55 kommuniziert dabei über einen Datentransfer 56 mit dem in das jeweilige Modul 2/3/4 eingesteckten Einsteckmodul 7. Der Datentransfer 56 kann dabei ein ebeninternes Datenprotokoll oder aber auch ein zentrales Datenprotokoll des gesamten Hardwaresystems 1 verwenden. Ebenfalls erfolgt eine Spannungsversorgung von dem Modul 2/3/4 zu dem Einsteckmodul 7, dass eine interne Versorgungsspannung 43, eine Modulebenenspannung 5 Volt 50 oder aber auch eine Modulebenenspannung 3,3 Volt 51 sein kann.

Von dem Einsteckmodul 7 aus wird dann die Systemgrenze des Hardwaresystems 1 verlassen und es erfolgt ein externer Datentransfer 57 mit einem an das Einsteckmodul 7 gekoppelten externen Element 58. Das externe Element 58 kann auch von dem Einsteckmodul 7 optional mit einem entsprechenden Laststrom 54 versorgt werden. Das Einsteckmodul 7 und das externe Element 58 nutzen zum externen Datentransfer 57 insbesondere das Datenprotokoll des externen Elements 58. In dem Einsteckmodul 7 selber sind bevorzugt sowohl Treiberhardware als auch Treibersoftware zum Betreiben oder zur Kommunikation mit dem externen Element 58 vorgesehen.

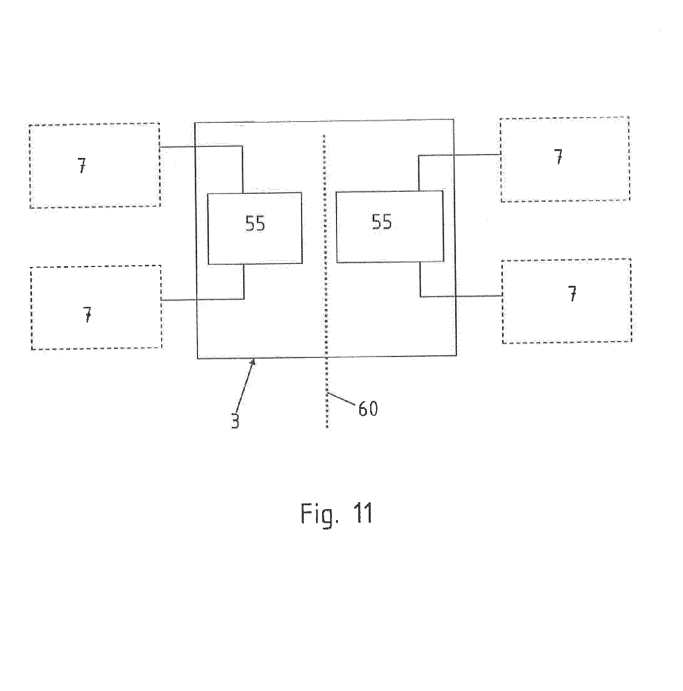

Figur 11 zeigt eine schematische Ansicht des spiegelsymmetrischen Aufbaus eines Zwischemoduls 3. An einer mittigen Spiegelebene 60 ist das Zwischenmodul 3 gespiegelt. Das Zwischenmodul 3 weist hierzu zwei Controller 55 auf, wobei jeder Controller 55 zwei Einsteckmodule 7 verwaltet. Im Rahmen der Erfindung ist es hierüber möglich, über ein Zwischenmodul 3 einen Programmablauf z. B. während eines Testzyklus, spiegelsymmetrisch parallel ablaufen zu lassen, wobei bei Ausfall einer Seite, die spiegelsymmetrische Seite dies redundant auffängt. Die Ausfallsicherheit kann beispielsweise dadurch noch weiter gesteigert werden, dass zwei Zwischenmodule 3 gespiegelt werden. Somit kann auf vier Controllern 55 der gleiche Programmablauf gefahren werden.

In besonders bevorzugter Ausführungsvariate ist jeder Controller 55 durch mindestens zwei Prozessoren, insbesondere drei, besonders bevorzugt vier, ganz besonders bevorzugt acht Prozessoren ausgebildet. Bei den Prozessoren handelt es sich besonders bevorzugt um RISC-Prozessoren. Durch den Aufbau eines Controllers 55 mit mindestens zwei Prozessoren ist es möglich, gleichzeitig zwei voneinander verschiedene Aufgaben in harter Echtzeit durchzuführen. So kann beispielsweise einer der Prozessoren die systemeigene Datenleitung, insbesondere den systemeigenen Bus auslesen bzw. überwachen, wobei der zweite Prozessor dann davon unabhängige bzw. verschiedene Aufgaben wahrnimmt. Diese Aufgaben können beispielsweise in der Kommunikation mit einem Einsteckmodul 7 und/oder einer Datenaufbereitung der Daten von dem Einsteckmodul 7 bestehen. Weiterhin können die aus dem systemeigenen Bus ausgelesenen Daten an das einsteckmodul weitergegebene werden, bzw. für dieses aufbereitet werden.

Ebenfalls können wiederum zwei Prozessoren redundant parallel arbeiten, so dass bei Ausfall eines Prozessors ein Funktionsprinzip durch den anderen Prozessor sichergestellt wird. Als besonderer Vorteil zeichnet sich bei dem erfindungsgemäßen Hardwaresystem durch den Aufbau mit mehreren Prozessoren die Arbeitsgeschwindigkeit aus. So ist es gegenüber herkömmlichen Controllern möglich, ohne Interrupt-Routinen zu arbeiten. Auch hierdurch wird wiederum die harte Echtzeitfähigkeit des erfindungsgemäßen Hardwaresystems sichergestellt. In besonders bevorzugter Ausführungsvariante werden Controller 55 mit acht Prozessoren eingesetzt, so dass sich bei einem spiegelsymmetrischen Aufbau auf einer Ebene 16 Prozessoren befinden.

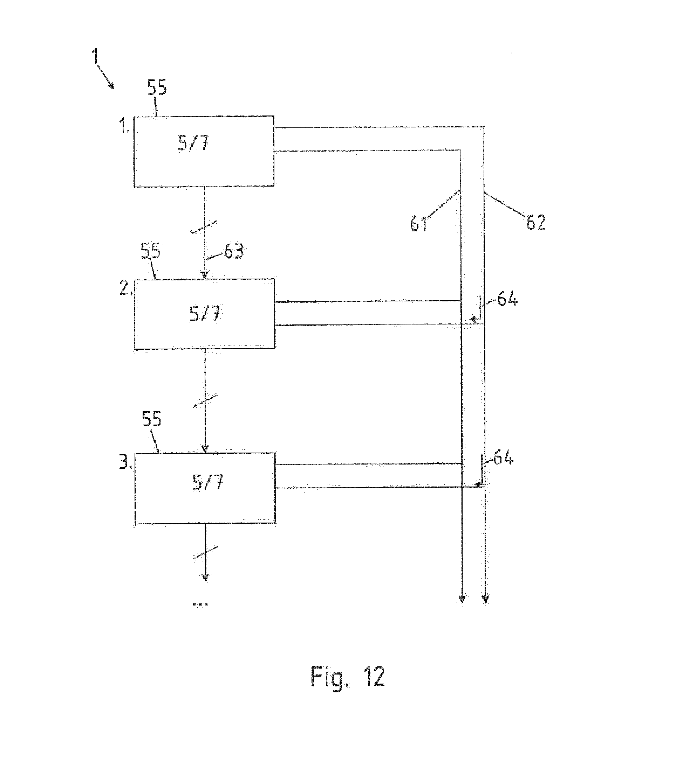

Figur 12 zeigt die erfindungsgemäße Möglichkeit der Autoadressierung des Hardwaresystems 1. Hierbei können die einzelnen Controller 55 der Modulebenen 5 oder aber auch ein jeweiliger Controller 55 eines Einsteckmoduls 7 innerhalb des Hardwaresystems 1 adressiert werden. Jeder Controller 55 muss dazu eine individuelle Nummer besitzen, um im Gesamthardwaresystem ansprechbar zu sein. Hierzu sind alle Controller 55 über Datenleitungen miteinander verbunden, die hier dargestellt in Form einer Senderleitung 61 und einer Empfängerleitung 62 ausgebildet sind. Die Controller 55 sind mit der Modularkonfiguration des Systems parallel an die Senderleitung 61 und die Empfängerleitung 62 angeschlossen.

Zur Autoadressierung müssen die Controller 55 jedoch in Reihe, also der Reihe nach, autoadressiert werden. Hierzu wird für einen ersten Controller 55 ein Resetsignal an den zweiten Controller 55 gesendet. Der erste Controller 55 bootet sich daraufhin neu. Er vertauscht seine Senderleitung 61 mit der Empfängerleitung 62, es wird also die Senderleitung 61 zur Empfängerleitung 62 und die Empfängerleitung 62 zur Senderleitung 61. Hierüber wird eine Kennung 64 an den zweiten Controller 55 gesendet. Der erste Controller 55 stellt anschließend seinen ursprünglichen Zustand von Senderdatum und Empfängerdatum wieder her. Daraufhin bootet der zweite Controller 55 neu und sendet an den dritten Controller 55 ebenfalls durch Vertauschen seiner Empfängerleitung 62 und Senderleitung 61 die Kennung 64 um plus 1 erhöht, woraufhin der dritte Controller 55 neu bootet. Die Autoadressierung kann sich folglich beliebig oft fortsetzen, wodurch das Hardwaresystem 1 mit durchaus bis zu mehr als 50 Controllern 55 erweiterbar ist. Die Controller 55 können untereinander mit einer Resetleitung 63 gekoppelt sein

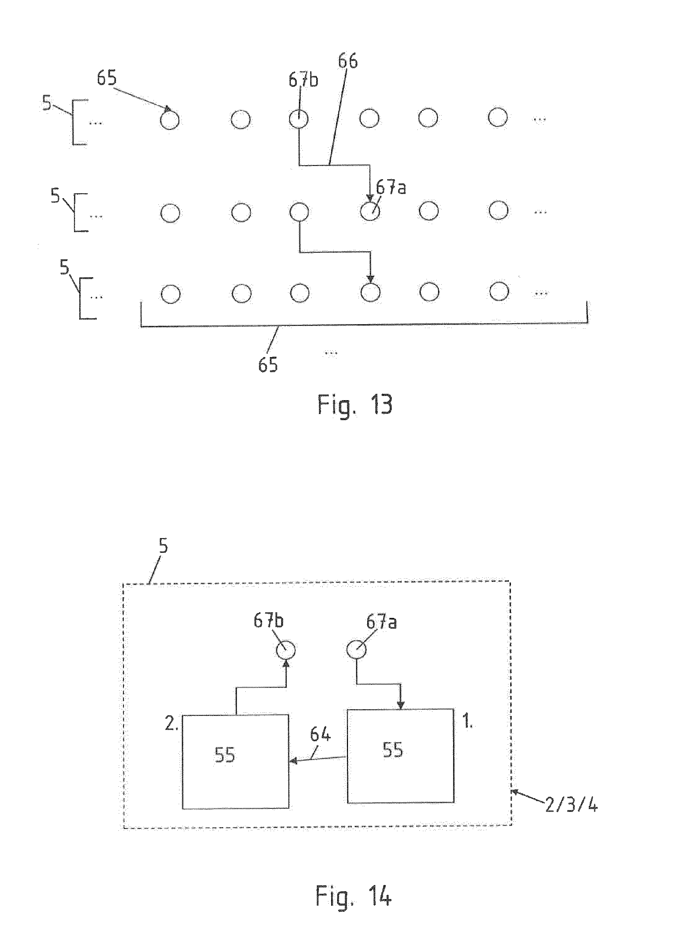

Damit die Controller ebenenübergreifend in Reihe schaltbar sind, muss ein jeweiliger Pfostenfeldstecker 65 einer Modulebene 5 einen Pinnversatz 66 der Resetleitung 67, die in Resetin 67a und Resetout 67b aufgeteilt ist, aufweisen. Hierdurch wird ebenenübergreifend, bei beliebiger modularer Erweiterungsmöglichkeit sichergestellt, dass das Resetsignal in Reihe weitergegeben wird, woraufhin sich die einzelnen Controller 55 fortlaufend autoadressieren. Dargestellt ist dies in Figur 13.

Figur 14 zeigt ergänzend, wie sich auf einer Modulebene 5, beispielsweise eines Grundmoduls 2 oder eines Zwischenmoduls 3 oder eines Deckelmoduls 4 zwei angeordnete Controller 55 entsprechend nacheinander autoadressieren. Zunächst kommt das Resetsignal über die Resetleitung 67 resetin 67a an, woraufhin der auf die Resetleitung 67 resetin 67a folgende erste Controller 55 sich bootet und das Resetsignal und die Kennung 64 um n plus 1 erhöht, an den zweiten Controller 55 auf der Modulebene 5 weitersendet, von wo aus das Resetsignal dann über die Restleitung 67 resetout auf die nächste, nicht näher dargestellte Modulebene 5 weitergegeben wird.

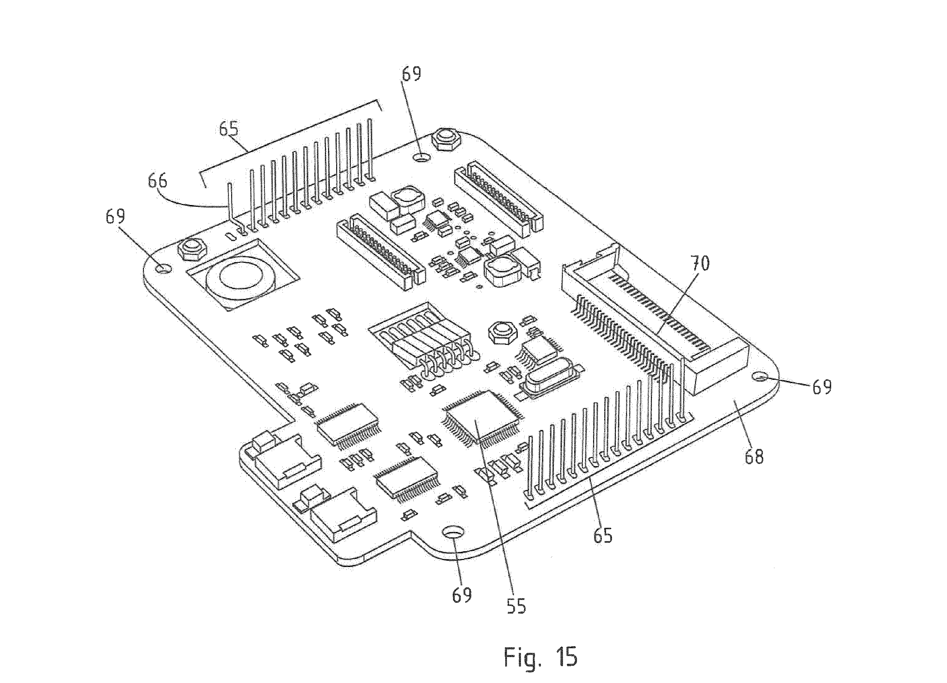

Figur 15 zeigt weiterhin eine Elektronikplatine 68, die dazu geeignet ist, in dem Gehäuse des erfindungsgemäßen Hardwaresystems 1 angeordnet zu werden. Die in Figur 15 gezeigte Platine eignet sich insbesondere zur Anordnung in dem Deckelmodul 4. Die Platine weist diverse Elektronikbauteile sowie mindestens einen Controller 55 auf. In Eckbereichen weist die Platine wiederum Montagelöcher 69 auf, die auf den Montagesockeln 25 in den einzelnen Modulebenen 5 anordnenbar sind und mit diesen verschraubbar sind. Ferner weist die Elektronikplatine 68 einen Pfostenfeldstecker 65 auf, wobei der auf die Bildebene bezogene hintere Pfostenfeldstecker einen Pinversatz 66 aufweist. Der Pinversatz 66 wird zur Autoadressierung genutzt. Ebenfalls ist ein Einsteckschachtstecker auf der Elektronikplatine angeordnet, in den das in einem Einsteckschacht 10 eingesteckte Einsteckmodul 7 lösbar steckbar ist.

### Bezugszeichen:

- 1 -: Hardwaresystem
- 2 -: Grundmodul
- 3 -: Zwischenmodul
- 4 -: Deckelmodul
- 5 -: Modulebene zu 2 bis 4
- 6 -: Zwischenschicht
- 7 -: Einsteckmodul
- 8 -: Kartenabschnitt zu 7
- 9 -: Modulabschnitt zu 7
- 10 -: Einstecköffnung zu 3
- 11 -: Stecker
- 12 -: Display
- 13-: Taster
- 14 -: Oberseite
- 15 -: vordere Einsteckseite
- 16 -: hintere Einsteckseite
- 17 -: vordere Seitenwand
- 18 -: hintere Seitenwand
- 19 -: Unterseite
- 20 -: Spannungsanschluss
- 21 -: abgerundete Ecke
- 22 -: Gehäusewandung zu 15/16
- 23 -: Gehäusewandung zu 17118
- 24 -: Ausnehmung
- 25 -: Montagesockel
- 26 -: innere Rundung
- 27 -: Montagelöcher zu 25
- 28 -: Montagelöcher zu 23/22
- 29 -: Magnet
- 30 -: Montageunterseite
- 31 -: Steckeröffnung
- 32 -: Öffnung zu 20
- 33 -: Adapterstück zu 20
- 34 -: Schraubverbindung
- 35 -: Fuß
- 36 -: Steckeröffnung
- 37 -: Anlagefläche
- 38 -: Einsteckmodulmagnet
- 39 -: D-Sub-Stecker
- 40 -: Pol
- 41 -: Sicherungsschraube
- 42 -: externe Versorgungsspannung
- 43 -: interne Versorgungsspannung
- 44 -: Netzteil
- 45 -: Akkumulator
- 46 -: Kraftfahrzeugbordnet
- 47 -: Versorgungsleitung
- 48 -: Spannungswandler 5 Volt
- 49 -: Spannungswandler 3,3 Volt
- 50 -: Modulebenenspannung 5 Volt
- 51 -: Modulebenenspannung 3,3 Volt
- 52 -: Lastversorgungsspannung
- 53 -: Leistungstreiber
- 54 -: Laststrom
- 55 -: Controller
- 56 -: Datentransfer
- 57 -: externer Datentransfer
- 58 -: externes Element
- 59 -: Treiber
- 60 -: Spiegelebene
- 61 -: Senderleitung
- 62 -: Empfängerleitung
- 63 -: Resetleitung
- 64 -: Kennung
- 65 -: Pfostenfeldstecker
- 66 -: Pinnversatz
- 67 -: Resetleitung
- 67a -: Resetin
- 67b -: Resetout
- 68 -: Elektronikplatine
- 69 -: Montagelöcher
- 70 -: Einsteckschacht

- L -: Länge
- B -: Breite

## Patentansprüche

1. Hardwaresystem (1) zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen, aufweisend ein Grundmodul (2) mit einem Mastercontroller und mindestens ein in das Hardwaresystem (1) eingestecktes Einsteckmodul (7), **dadurch gekennzeichnet, dass** das Einsteckmodul (7) per Drahtlosdatenübertragung mit einem Sensor und/oder Aktor und/oder Datennetz kommuniziert.

2. Hardwaresystem nach Anspruch 1, **dadurch gekennzeichnet, dass** das Grundmodul (2) mit einem Zwischenmodul (3) erweiterbar ist, wobei das Zwischenmodul (3) in turmbauweise oder sandwichbauweise an das Grundmodul (2) anschließbar ist.

3. Hardwaresystem nach Anspruch 1 oder 2, **dadurch gekennzeichnet, dass** das Grundmodul (2) eine zentrale Spannungsversorgung aufweist, wobei das Grundmodul (2) das Einsteckmodul (7) und das mindestens eine Zwischenmodul (3) mit einer Betriebsspannung versorgt.

4. Hardwaresystem nach Anspruch 2 oder 3, **dadurch gekennzeichnet, dass** das Grundmodul (2) eine Versorgungsspannung bereitstellt, wobei die Versorgungsspannung in dem Zwischenmodul (3) in eine Betriebsspannung des Einsteckmoduls (7) transformierbar ist.

5. Hardwaresystem nach einem der Ansprüche 1 bis 4, **dadurch gekennzeichnet, dass** das Grundmodul (2) an ein Kraftfahrzeugbordnetz anschließbar ist und/oder dass das Grundmodul (2) einen Akkumulator aufweist und/oder dass an das Grundmodul (2) ein Akkumulator angeschlossen ist.

6. Hardwaresystem nach einem der Ansprüche 1 bis 5, **dadurch gekennzeichnet, dass** dem Einsteckmodul (7) ein Empfangsmodul zuordnenbar ist, wobei das Einsteckmodul (7) und das Empfangsmodul über Drahltosdatenkommunikation miteinander verbindbar sind.

7. Hardwaresystem nach einem der Ansprüche 1 bis 6, **dadurch gekennzeichnet, dass** ein Einsteckmodul (7) ein Drahtlosdatenübertragungsbaustein aufweist.

8. Hardwaresystem nach einem der Ansprüche 1 bis 7, **dadurch gekennzeichnet, dass** das Grundmodul (2) und das Zwischenmodul (3) über einen systemeigenen Bus, vorzugsweise über einen SPI Bus, des Hardwaresystems (1) kommunizieren, wobei an das Zwischenmodul (3) mindestens ein Einsteckmodul (7) anschließbar ist und über das Einsteckmodul (7) externe Regler und/oder Messsensoren und/oder Aktoren und/oder Datennetze auslesbar und/oder steuerbar sind.

9. Hardwaresystem nach einem der Ansprüche 6 bis 8, **dadurch gekennzeichnet, dass** das Empfangsmodul an das Kraftfahrzeugbordnetz anschließbar ist und/oder einen Akkumulator aufweist.

10. Hardwaresystem nach einem der Ansprüche 1 bis 9, **dadurch gekennzeichnet, dass** das Grundmodul (2) mit Einsteckmodul (7) und optionalen Zwischenmodulen (3) sowie das dazugehörige Empfangsmodul mobil einsatzbar sind, insbesondere in Testfahrten für Kraftfahrzeuge.

11. Hardwaresystem nach einem der Ansprüche 1 bis 10, **dadurch gekennzeichnet, dass** das Empfangsmodul einen Treiber (59) aufweist, mit dem der an das Empfangsmodul angeschlossene Sensor und/oder Aktor regelbar und/oder steuerbar ist.

12. Hardwaresystem nach einem der Ansprüche 1 bis 11, **dadurch gekennzeichnet, dass** das Grundmodul (2), insbesondere das modular mit Zwischenmodulen (3) erweiterte Grundmodul (2), ein spritzwassergeschütztes und staubgeschütztes Gehäuse aufweist.

13. Verfahren zum Betreiben eines Hardwaresystems (1) nach mindestens einem der Ansprüche 1 bis 12, **dadurch gekennzeichnet, dass** das Grundmodul (2) mit dem Einsteckmodul (7) über einen systemeigenen Bus kommuniziert, wobei das Einsteckmodul (7) die für seine Verwendung relevanten Daten aus dem systemeigenen Bus ausliest und per Drahtlosdatenübertragung an das Empfangsmodul sendet.

14. Verfahren nach Anspruch 13, **dadurch gekennzeichnet, dass** das Grundmodul (2) und das Zwischenmodul (3) über den systemeigenen Bus kommunizieren, wobei das Zwischenmodul (3) die für in dem Zwischenmodul (3) angeordneten Einsteckmodule (7) relevanten Daten ausliest und an die Einsteckmodule (7) weiterleitet, wobei die Einsteckmodule (7) mit einem jeweiligen Empfangsmodul per Drahtlosdatenübertragung kommunizieren.

15. Verfahren nach Anspruch 13 oder 14, **dadurch gekennzeichnet, dass** mit einem Einsteckmodul (7) mindestens zwei Empfangsmodule angesteuert werden, wobei die Empfangsmodule voneinander verschiedene Aufgaben wahrnehmen.

16. Verfahren nach einem der Ansprüche 13 bis 15, **dadurch gekennzeichnet, dass** die Empfangsmodule und/oder Einsteckmodule (7) und/oder Zwischenmodule (3) in einen energiearmen Modus geschaltet werden, sobald kein Datenaustausch stattfindet, wobei die Module in Echtzeit wieder in den Normalmodus geschaltet werden, sobald ein Datenaustausch beginnt.

17. Verfahren nach einem der Ansprüche 13 bis 16, **dadurch gekennzeichnet, dass** standardisierte Drahtlosdatenübertragungsprotokolle von einem Einsteckmodul (7) ausgelesen und/oder gesendet werden, so dass das Einsteckmodul (7) mit handelsüblichen Drahtlosdatenempfängern und/oder Drahtlosdatenschnittstellen kommunizieren kann.
